(19) Europäisches Patentamt
European Patent Office
Office européen des brevets

(11) **EP 3 899 497 B1**

(12) **FASCICULE DE BREVET EUROPEEN**

(45) Date de publication et mention
de la délivrance du brevet:
**09.08.2023  Bulletin 2023/32**

(21) Numéro de dépôt: **19845705.3**

(22) Date de dépôt: **17.12.2019**

(51) Classification Internationale des Brevets (IPC):
**G01N 21/21** *(2006.01)*    **G01N 21/39** *(2006.01)*
**H01S 5/062** *(2006.01)*    **H01S 5/0687** *(2006.01)*
**H01S 5/183** *(2006.01)*    **H01S 5/00** *(2006.01)*
**H01S 5/0683** *(2006.01)*

(52) Classification Coopérative des Brevets (CPC):
**G01N 21/211; H01S 5/005; H01S 5/06213;
H01S 5/06246; H01S 5/06832;** G01N 2021/399;
G01N 2201/0612; H01S 5/0622; H01S 5/183;
H01S 2301/163

(86) Numéro de dépôt international:
**PCT/FR2019/053109**

(87) Numéro de publication internationale:
**WO 2020/128293 (25.06.2020 Gazette 2020/26)**

(54) **DISPOSITIF LASER POUR INTERFEROMETRIE A POLARISATION**

LASERVORRICHTUNG ZUR POLARISATIONSINTERFEROMETRIE

LASER DEVICE FOR POLARIZATION INTERFEROMETRY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **18.12.2018  FR 1873212**

(43) Date de publication de la demande:
**27.10.2021  Bulletin 2021/43**

(73) Titulaires:
• **Université de Technologie de Troyes
  10000 Troyes (FR)**
• **Phaselab Instrument
  10430 Rosières-Prés-Troyes (FR)**

(72) Inventeurs:
• **VAILLANT, Julien
  10300 SAINTE-SAVINE (FR)**
• **BRUYANT, Aurélien
  10120 SAINT-ANDRE-LES-VERGERS (FR)**
• **WU, Tzu-Heng
  YI-LAN  CITY, 26059 (TW)**

(74) Mandataire: **Novagraaf Technologies
Bâtiment O2
2, rue Sarah Bernhardt
CS90017
92665 Asnières-sur-Seine Cedex (FR)**

(56) Documents cités:
**US-A- 5 305 330      US-A- 5 374 991
US-B1- 7 233 396**

• **Aurélien Bruyant ET AL: "Interferometry Using
  Generalized Lock-in Amplifier (G-LIA): A Versatile
  Approach for Phase-Sensitive Sensing and
  Imaging" In: "Optical Interferometry", 15 février
  2017 (2017-02-15), InTech, XP055635442, ISBN:
  978-953-51-2956-1 pages 211-210, DOI:
  10.5772/66657, alinéa [003.] - alinéa [004.] figures
  4-6,9-11**
• **WATKINS L R: "Novel interferometric
  ellipsometer with wavelength swept source",
  LASERS AND ELECTRO-OPTICS, 2004. (CLEO).
  CONFERENCE ON SAN FRANCISCO, CA, USA
  MAY 20-21, 2004, PISCATAWAY, NJ, USA,IEEE,
  vol. 1, 17 mai 2004 (2004-05-17), pages 1043-1045,
  XP010745760, ISBN: 978-1-55752-777-6**

**Description**

La présente invention concerne de manière générale le domaine de l'interférométrie et la réduction de bruit dans les interféromètres et autres dispositifs de mesure dérivés ou couplés à des interféromètres tels que des ellipsomètres ou des biocapteurs.

Il est connu d'utiliser des dispositifs interférométriques pour des mesures ellipsométriques, tels que dans le brevet européen EP1893977B1 ou dans le brevet français FR2685962. Il est également connu d'utiliser des dispositifs interférométriques pour des mesures de résonance de plasmon de surface (SPR) permettant de détecter des cibles moléculaires, par exemple dans les demandes de brevet international WO2017153378 des inventeurs de la présente demande et WO2009080998A2, ou le brevet américain US7233396B2. Ces dispositifs mettent en oeuvre souvent du matériel encombrant et coûteux, tels que des modulateurs acousto-optiques, des modulateurs photo-élastiques, ou des rhomboèdres de Fresnel.

Les documents suivants concernent le domaine de l'invention :

- Aurélien Bruyant ET AL : « Interferometry Using Generalized Lock-in Amplifier (G-LIA): A versatile approach for Phase-Sensitive Sensing and Imaging" in "Optical Interferometry", 15 février 2017, InTech, XP55635442, pages 210-211;

- US 5305330A;

- US 5374991 A;

Watkins L R: "Novel interferometric ellipsometer with wavelength swept source", LASER AND ELECTRO-OPTICS, 2004 (CLEO), CONFERENCE ON SAN FRANCISCO, CA, USA, May 20-21, 2004, Piscataway, NJ, USA, IEEE, vol. 1, 17 mai 2004, pages 1043-1045, XP010745760.

Dans les deux cas, mesures ellipsométriques ou mesures par résonance de plasmon de surface, une grande résolution en phase est nécessaire afin d'améliorer la sensibilité des mesures. Cette grande résolution peut être apportée par une modulation temporelle de la phase des signaux traversant les dispositifs de mesure. En effet, un avantage intrinsèque des divers systèmes à modulation de phase par rapport à d'autre systèmes de mesure de signaux stationnaires dépourvus de modulateur de phase est la réduction de bruit que permet une analyse fréquentielle dans la récupération de l'amplitude et de la phase, notamment grâce à l'emploi de détections synchrones aux fréquences de modulation du signal interférométrique détecté. Le brevet américain US5485271A décrit un ellipsomètre interférométrique incorporant un modulateur de phase électro-optique. D'autres techniques permettent une modulation de phase obtenue par modulation de la biréfringence d'un composant du dispositif de mesure, telles celles décrites dans le brevet américain US7339681 B2, où une cellule à cristaux liquides est utilisée, ou dans le brevet américain US8004676B1, où un modulateur photo-élastique est utilisé. Aussi, une modulation de phase peut être obtenue par modulation de la longueur d'onde du faisceau source, comme dans la demande de brevet international WO2017/153378, proposé par les présents inventeurs, qui décrit un interféromètre compact ainsi qu'un capteur biochimique en dérivant, mais qui nécessite une puce optique particulière produisant deux réflexions, issues de deux couches distantes pour réaliser cette modulation, ce qui limite son application à des échantillons particuliers et ne permet pas une condition d'excitation optique quelconque.

Il est par ailleurs connu d'utiliser des interféromètres dits à chemin commun, dans lesquels le faisceau de référence et le faisceau signal lié à un échantillon se déplacent autant que possible le long d'un même trajet, pour réduire le bruit des mesures interférométriques, du fait de la bonne immunité de ce type d'interféromètres vis-à-vis des vibrations environnementales.

Il est connu également d'utiliser des interféromètres asymétriques où la différence de chemin optique entre les deux bras interférant est suffisamment grande pour qu'une faible modulation de longueur d'onde de la source de lumière utilisée entraîne une modulation de phase suffisante pour pouvoir extraire un signal d'amplitude et un signal de phase du signal interférométrique comme expliqué par Vaillant et al. dans « An unbalanced interferometer insensitive to wavelength drift ». Sensors and Actuators A: Physical, 268, 188-192 (2017). Dans ce type de dispositifs cependant, le chemin géométrique des deux faisceaux n'est pas commun, limitant ainsi la stabilité du système.

En outre, l'inconvénient des techniques précédemment citées réside dans l'encombrement de leur dispositif de mise en oeuvre ainsi que dans leur coût, afin d'obtenir une grande précision et une grande sensibilité de mesure. Une approche intéressante pour minimiser le bruit des interféromètres consiste à utiliser un interféromètre à polarisation qui mesure le déphasage entre deux composantes orthogonales du champ, car dans ce cas le trajet suivi par les deux composantes du champ peut être relativement commun. Néanmoins la modulation de phase d'une composante par rapport à l'autre nécessite une séparation optique des faisceaux et un appareillage particulier comme ceux mentionnés précédemment, comme par exemple un modulateur photo-élastique.

Le problème technique que se propose de résoudre les inventeurs est de simplifier la mise en oeuvre et d'améliorer la sensibilité d'appareils de mesure interférométriques de type interféromètre à polarisation, et l'intégration de ce type d'appareil aussi bien au sein d'ellipsomètres qu'au sein de dispositifs SPR et d'en réduire l'encombrement et le poids en évitant l'emploi de modulateurs de phase actifs conventionnels et l'usage de pièces mobiles pour déterminer l'état du déphasage au sein dudit interféromètre à polarisation.

Afin de résoudre ce problème tout en palliant les inconvénients précités, le demandeur a mis au point un dispositif laser pour interférométrie à polarisation, adapté pour délivrer un faisceau laser modulé temporellement en phase selon la revendication 1.

Avantageusement, la source laser monomode longitudinal du dispositif laser peut être un laser à semi-conducteur modulable en longueur d'onde par le courant électrique d'alimentation du laser sur une plage d'accordabilité inférieure à un millième de la longueur d'onde. Cette faible accordabilité est réalisée par l'essentiel des diodes laser grand public.

De préférence, le laser à semi-conducteur pouvant constitué la source laser monomode longitudinal du dispositif laser peut être une diode laser à cavité verticale émettant par la surface dite VCSEL. Cependant, à défaut de VCSEL, des lasers plus largement accordables et typiquement plus onéreux peuvent être utilisés.

Par ailleurs, l'élément retardateur de phase passif du dispositif laser peut comprendre un cristal biréfringent ayant un axe optique orienté selon l'une des dites composantes de polarisation TE ou TM du faisceau laser source $S_{source}$.

Le dispositif laser peut de plus comprendre :

- un séparateur de faisceau de référence en sortie de l'élément retardateur de phase destiné à séparer le faisceau en au moins deux parties $S_{référence}$ et $S_{modulé}$, la première partie $S_{référence}$ étant une portion de référence du faisceau laser modulé temporellement en phase $S_{modulé}$, et ledit séparateur de faisceau étant configuré pour propager la portion de référence dans une direction différente de celle du faisceau laser modulé temporellement en phase $S_{modulé}$,
- un photo-détecteur de référence comprenant une entrée destinée à recevoir par l'intermédiaire d'un polariseur de référence ladite portion de référence $S_{référence}$, et ledit photo-détecteur de référence étant configuré pour générer un premier signal interférométrique, sous forme d'un premier signal électrique modulé $I_{ref}$ représentatif de ladite portion de référence $S_{référence}$,
- une unité d'analyse électronique de référence configurée pour recevoir et analyser ledit signal électrique $I_{ref}$ pour extraire un déphasage moyen $\Delta_{ref}$ entre les deux composantes orthogonales transverse électrique TE et transverse magnétique TM de la portion de référence $S_{référence}$,

ledit signal électrique modulé $I_{ref}$ représentatif de ladite portion de référence $S_{référence}$ incluant un terme d'amplitude $A_{ref}$ proportionnel au produit des amplitudes des deux composantes transverse électrique TE et transverse magnétique TM et un terme de phase,

ladite unité d'analyse électronique de référence étant configurée pour, par analyse dudit signal électrique $I_{ref}$, extraire le déphasage moyen $\Delta_{ref}$ entre les deux composantes transverse électrique TE et transverse magnétique TM de la portion de référence $S_{référence}$, et extraire ledit terme d'amplitude $A_{ref}$, et

l'unité d'analyse électronique de référence étant en outre configurée pour fournir un coefficient de correction au moyen de modulation temporelle de la source de sorte à ajuster la modulation temporelle de la source laser et à en stabiliser la longueur d'onde $\lambda$ moyenne par stabilisation du déphasage moyen $\Delta_{ref}$.

Avantageusement, ladite unité d'analyse électronique de référence est reliée au moyen de modulation temporelle de la source laser de sorte à constituer une boucle d'asservissement pour stabiliser le déphasage moyen $\Delta_{ref}$.

De manière optionnelle, pour faciliter l'alignement, il peut être utile d'utiliser des séparateurs de faisceau possédant des traitements réfléchissant ou anti-réfléchissant sur différentes interfaces pour éviter d'avoir des réflexions multiples parasites. D'autres moyens peuvent néanmoins être employés seuls ou en sus pour supprimer les réflexions multiples parasites comme l'utilisation de faces non parallèles, ou/et en discriminant spatialement la première réflexion et la première transmission, ceci incluant l'utilisation de lames épaisses.

La présente demande propose également un interféromètre à polarisation configuré pour mesurer des caractéristiques d'un échantillon, selon la revendication 7.

Le signal électrique modulé $I_{échantillon}$ représentatif du faisceau de sortie $S_{échantillon}$ inclut un terme d'amplitude $A_{échantillon}$ proportionnel au produit des amplitudes des deux composantes transverse électrique TE et transverse magnétique TM du faisceau de sortie $S_{échantillon}$ et un terme de phase $\Delta_{échantillon}$ incluant un incrément de déphasage optique $\Delta$ entre les deux composantes transverse électrique TE et transverse magnétique TM induit par l'échantillon. En conséquence, l'unité d'analyse électronique est configurée pour, par analyse dudit signal électrique $I_{échantillon}$, extraire ledit terme d'amplitude $A_{échantillon}$ et ledit terme de phase moyen $\Delta_{échantillon}$ entre les deux composantes transverse électrique TE et transverse magnétique TM du faisceau de sortie $S_{échantillon}$ permettant de déterminer les caractéristiques optiques dudit échantillon. Lorsque le dispositif laser comprend en outre:

- un séparateur de faisceau de référence en sortie de l'élément retardateur de phase configuré pour séparer le faisceau en au moins deux parties $S_{\text{référence}}$ et $S_{\text{modulé}}$, ladite partie $S_{\text{référence}}$ étant une portion de référence du faisceau laser modulé temporellement en phase $S_{\text{modulé}}$, et étant configurée pour se propager dans une direction différente de celle du faisceau laser modulé temporellement en phase $S_{\text{modulé}}$,

- un photo-détecteur de référence comprenant une entrée configurée pour recevoir par l'intermédiaire d'un polariseur de référence ladite portion de référence $S_{\text{référence}}$, et ledit photo-détecteur de référence étant configuré pour générer un premier signal interférométrique, sous forme d'un premier signal électrique modulé $I_{\text{ref}}$ représentatif de ladite portion de référence $S_{\text{référence}}$,

- une unité d'analyse électronique de référence configurée pour recevoir et analyser ledit signal électrique $I_{\text{ref}}$ et déterminer $\Delta_{\text{échantillon}}$ et $A_{\text{échantillon}}$, alors l'incrément de déphasage optique $\Delta$ induit par l'échantillon est obtenu par la formule

$$\Delta = \Delta_{\text{échantillon}} - \Delta_{\text{ref}} \text{ à une constante additive près.}$$

La présente demande propose également un ellipsomètre configuré pour déterminer un paramètre ellipsométrique $\Delta_{\text{ellipsométrie}}$ d'un échantillon, selon la revendication 9.

Dans une première variante de l'ellipsomètre proposé, ce dernier peut comprendre en outre une première voie de détection supplémentaire, ladite première voie de détection supplémentaire comprenant :

- un premier dispositif séparateur de faisceau sélectif en polarisation, configuré pour prélever une portion du faisceau de sortie $S_{\text{échantillon}}$ et sélectionner une des deux composantes transverse électrique TE et transverse magnétique TM du faisceau de sortie $S_{\text{échantillon}}$ sous la forme d'un faisceau $S_{\tan\Psi}$ appelé portion polarisée,
- un photo-détecteur pour ellipsométrie complète configuré pour recevoir ladite portion polarisée $S_{\tan\Psi}$ et générer un signal électrique $I_{\tan\Psi}$ caractéristique de l'intensité lumineuse de la portion polarisée,

où ladite première voie de détection supplémentaire est configurée pour déterminer le paramètre ellipsométrique $\tan\Psi$ de l'échantillon à l'aide des signaux électriques $I_{\text{échantillon}}$ et $I_{\tan\Psi}$ issus respectivement du photo-détecteur d'analyse et du photo-détecteur pour ellipsométrie complète.

Dans une deuxième variante de l'ellipsomètre proposé, différente de la première variante décrite ci-dessus, celui-ci peut comprendre en outre une deuxième voie de détection supplémentaire, ladite deuxième voie de détection supplémentaire comprenant :

- un deuxième dispositif séparateur de faisceau sélectif en polarisation configuré pour prélever une portion du faisceau de sortie $S_{\text{échantillon}}$ et sélectionner les deux composantes transverse électrique TE et transverse magnétique TM du faisceau de sortie $S_{\text{échantillon}}$ sous la forme de deux faisceaux $S_{\tan\Psi\_TE}$ et $S_{\tan\Psi\_TM}$ appelés respectivement portion polarisée TE et portion polarisée TM,
- deux photo-détecteurs appelés photo-détecteur TE et photo-détecteur TM configurés pour recevoir respectivement lesdites portion polarisée TE $S_{\tan\Psi\_TE}$ et portion polarisée TM $S_{\tan\Psi\_TM}$ et pour générer respectivement un signal électrique $I_{\tan\Psi\_TE}$ caractéristique de l'intensité lumineuse de la portion polarisée TE $S_{\tan\Psi\_TE}$ et un signal électrique $I_{\tan\Psi\_TM}$ caractéristique de l'intensité lumineuse de la portion polarisée TM $S_{\tan\Psi\_TM}$,

dans lequel

la deuxième voie de détection supplémentaire est configurée pour déterminer le paramètre ellipsométrique $\tan\Psi$ de l'échantillon à l'aide des signaux électriques $I_{\tan\Psi\_TE}$ et $I_{\tan\Psi\_TM}$ issus des photo-détecteur TE et photo-détecteur TM.

La présente demande propose aussi un biocapteur de type système de détection à résonance de plasmon de surface configuré pour déterminer des caractéristiques d'un échantillon constitué d'une couche microfluidique MF, correspondant au milieu biologique ou biochimique à analyser, selon la revendication 12.

D'autres avantages et particularités de la présente demande résulteront de la description qui va suivre, donnée à titre d'exemple non limitatif et faite en référence aux figures annexées :

La figure 1a illustre de manière schématique un premier mode de réalisation d'un dispositif laser tel que proposé ;
La figure 1b illustre de manière schématique un deuxième mode de réalisation d'un dispositif laser tel que proposé ;
La figure 2a illustre de manière schématique un premier mode de réalisation d'un interféromètre à polarisation tel que proposé ;
La figure 2b illustre de manière schématique un deuxième mode de réalisation d'un interféromètre à polarisation tel que proposé ;
La figure 3a illustre de manière schématique la partie nommée A d'un interféromètre à polarisation tel que proposé pour la mise en oeuvre d'une première variante d'un ellipsomètre pour ellipsométrie complète ;

La figure 3b illustre de manière schématique la partie nommée A d'un interféromètre à polarisation tel que proposé pour la mise en oeuvre d'une deuxième variante d'un ellipsomètre pour ellipsométrie complète ;

La figure 4a montre des résultats expérimentaux obtenus avec un ellipsomètre pour ellipsométrie complète ;

La figure 4b montre des résultats expérimentaux obtenus avec un ellipsomètre pour ellipsométrie complète ;

La figure 5 illustre de manière schématique la partie nommée A d'un interféromètre à polarisation tel que proposé pour la mise en oeuvre d'un biocapteur de type système de détection à résonance plasmon de surface ;

La figure 6a montre des résultats expérimentaux obtenus avec un biocapteur de type système de détection à résonance plasmon de surface comme illustré sur la figure 5 ; et

La figure 6b montre des résultats expérimentaux obtenus avec un biocapteur de type système de détection à résonance plasmon de surface comme illustré sur la figure 5.

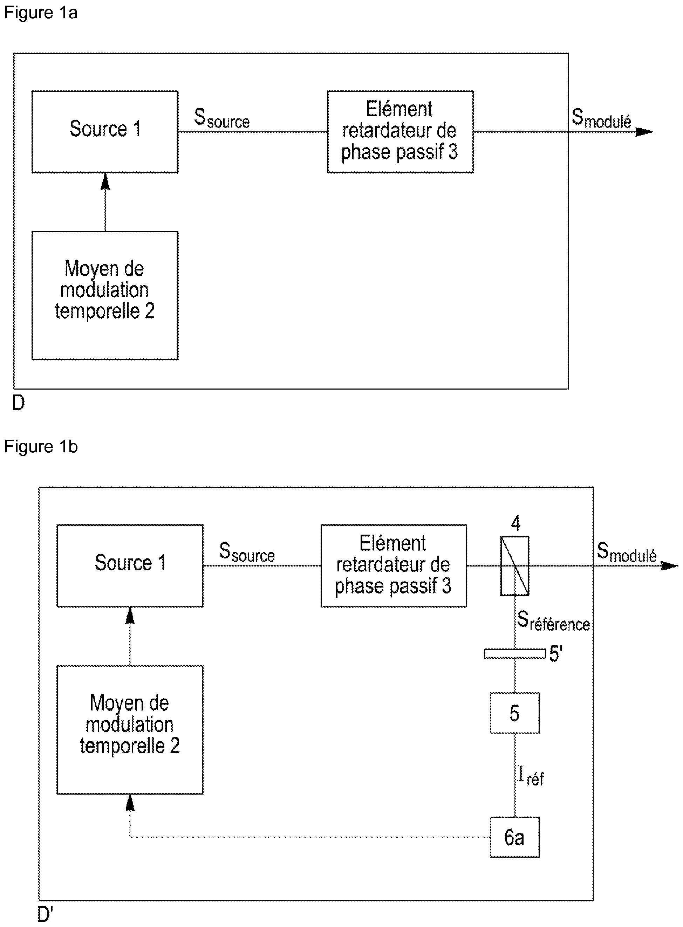

Les figures 1 à 6b sont commentées plus en détail au niveau de la description détaillée et des exemples qui suivent, qui illustrent l'invention sans en limiter la portée.

## DESCRIPTION DETAILLEE

En référence à la figure 1a, un premier mode de réalisation d'un dispositif laser D comprend une source laser monomode longitudinal 1. Par source monomode longitudinal, on entend une source laser comprenant un mode unique, ou une source laser présentant essentiellement un mode longitudinal principal et éventuellement d'autres modes longitudinaux suffisamment faibles, en comparaison, pour être ignorés ou filtrés. La source n'est pas nécessairement monomode transverse, dans le sens où une distribution spatiale de champ éventuellement complexe peut être employée pourvu que le champ puisse être considéré comme monochromatique. Cette source laser 1 est alimentée par un courant d'alimentation électrique. La longueur d'onde λ de la source laser monomode 1 est modulée temporellement par un moyen de modulation temporelle 2. Le faisceau laser source $S_{source}$ issu de la source laser 1 comprend deux composantes de polarisation rectilignes orthogonales non nulles nommées transverse électrique, TE, et transverse magnétique, TM. Le faisceau laser source $S_{source}$ traverse un élément retardateur de phase passif 3 qui introduit un déphasage entre les composantes TE et TM du faisceau laser source $S_{source}$. Du fait de la modulation temporelle de la longueur d'onde de la source laser 1, le déphasage entre les composantes TE et TM est aussi modulé temporellement. Ainsi, le faisceau issu de l'élément retardateur de phase passif 3 est un faisceau laser modulé temporellement en phase $S_{modulé}$. Par faisceau laser modulé en phase, on entend un faisceau laser dans lequel les deux composantes de polarisations sont modulées l'une par rapport à l'autre. Dans ledit dispositif, la modulation de phase peut être réalisée en conservant un chemin géométrique constant pour les deux composantes du champ et sans dispositif de modulation actif autre que la modulation de la source laser elle-même, le composant où se produit la modulation étant passif.

Pour être plus précis, lorsqu'il est énoncé que la modulation de phase peut être réalisé en conservant un chemin géométrique constant pour les deux composantes du champ, il doit être compris que le chemin géométrique parcouru par les deux composantes du champ ne change pas dans le temps, notamment au niveau de l'élément où se produit le déphasage entre ces composantes, c'est-à-dire dans l'élément retardateur de phase passif qui est donc fixe et avantageusement monolithique pour une meilleure stabilité.

De préférence, la source laser 1 est un laser à semi-conducteur, par exemple une diode laser à cavité verticale émettant par la surface VCSEL.

Par ailleurs, la modulation temporelle de la longueur d'onde de la source laser 1 peut être effectuée en modulant temporellement le courant électrique d'alimentation de la source laser 1. La modulation temporelle de la longueur d'onde de la source laser 1 est typiquement réalisée sur une plage d'accordabilité inférieure à un millième de la longueur d'onde. Ainsi, il n'est pas nécessaire de recourir à une modulation de biréfringence ou un autre type de modulateur pour provoquer cette modulation de phase entre lesdites composantes du champ.

En particulier, l'élément retardateur de phase passif 3 peut par exemple comprendre ou consister en un composant présentant une biréfringence, tel qu'un cristal biréfringent. Dans ce cas particulier, le cristal biréfringent possède avantageusement un axe optique selon l'une des deux composantes transverses orthogonales de polarisation du faisceau laser source. Conventionnellement, ces deux composantes de polarisation sont nommées TE et TM pour « transverse électrique » et « transverse magnétique » en référence à un certain plan d'incidence prédéterminé. Le chemin géométrique suivi par les composantes du champ TE et TM peut alors être entièrement commun. La modulation de phase entre les deux composantes du champ est ainsi générée indépendamment de la nature d'un éventuel échantillon interceptant le faisceau, et des optiques utilisées pour exciter l'échantillon comme des lentilles, des prismes ou des réseaux de couplage.

Par chemin géométrique commun, il doit être compris que les faisceaux lumineux des composantes du champ TE et TM sont spatialement superposés. Une telle configuration permet, par exemple, une mise en commun du bruit subi par les différents faisceaux, rendant le dispositif plus stable, ceci malgré la différence des chemins optiques parcourus par les composantes TE et TM. Il est rappelé que le chemin optique est défini par le produit de l'indice de réfraction rencontré par le chemin géométrique.

Les optiques utilisées pour exciter l'échantillon, citées au paragraphe précédent, permettent par exemple de définir le ou les angles d'incidence et plus généralement les conditions d'éclairage sur l'échantillon. Par l'expression « exciter l'échantillon », il est entendu de générer, à l'aide du dispositif laser, un champ électromagnétique, au sein de l'échantillon.

Différents éléments peuvent également être ajoutés à ce dispositif, notamment en vue de stabiliser ou même de contrôler le déphasage moyen existant entre les deux composantes du champ ou plus généralement pour contrôler l'état de polarisation émanant du dispositif laser. En particulier, en référence à la figure 1b, le dispositif laser D peut en outre posséder un bras de référence comprenant un séparateur de faisceau de référence 4 qui permet de prélever en sortie de l'élément retardateur de phase passif 3 une portion de référence du faisceau laser modulé temporellement en phase $S_{\text{modulé}}$, appelée $S_{\text{référence}}$, se propageant dans une autre direction que celle du faisceau laser modulé temporellement en phase $S_{\text{modulé}}$. Cette portion de référence $S_{\text{référence}}$ est envoyée vers un polariseur de référence 5' à travers lequel les deux composantes TE et TM de cette portion de référence $S_{\text{référence}}$ interfèrent. Suite à son passage à travers le polariseur de référence 5', la portion de référence $S_{\text{référence}}$ est interceptée par un photo-détecteur de référence 5 qui délivre un signal électrique modulé $I_{\text{ref}}$.

Ce signal électrique modulé $I_{\text{ref}}$ est reçu et analysé par une unité d'analyse électronique de référence 6a. Le signal électrique modulé $I_{\text{ref}}$ inclut un terme interférométrique modulé temporellement en phase et présentant une amplitude $A_{\text{ref}}$ proportionnelle au produit des amplitudes des deux composantes transverse électrique TE et transverse magnétique TM de la portion de référence $S_{\text{référence}}$.

En effet, le signal électrique modulé $I_{\text{ref}}$ représente le signal interférométrique détecté par le photo-détecteur de référence, qui peut s'écrire sous la forme :

$$I_{ref} \propto E_{TE}^2 + E_{TM}^2 + 2mE_{TE}E_{TM}cos\left(\Delta_{mod} + \Delta_{ref}\right) = E_{TE}^2 + E_{TM}^2 + A_{ref}^2 cos\left(\Delta_{mod} + \Delta_{ref}\right)$$

où

$E_{TE}$ et $E_{TM}$ sont les amplitudes des composantes TE et TM de la portion de référence $S_{\text{référence}}$,

M est un coefficient inférieur ou égal à 1, et

$$A_{ref}^2 = 2mE_{TE}E_{TM},$$

et

$\Delta_{mod}$ est un terme de phase modulé temporellement, préférablement sinusoïdalement, mais pas nécessairement, suivant le choix de la fonction de modulation du courant. L'analyse de ce type de signal modulé $I_{\text{ref}}$ est en particulier détaillée dans les références Al Mohtar, Abeer, et al. "Generalized lock-in détection for interferometry: application to phase sensitive spectroscopy and near-field nanoscopy." Optics express 22.18 (2014): 22232-22245 et le brevet US9518869B2 qui propose l'utilisation d'une détection synchrone modifiée dites détection synchrone généralisée pour effectuer l'analyse. L'emploi d'une détection synchrone généralisée permet effectivement d'extraire les informations d'amplitude $A_{\text{ref}}$ et de phase $\Delta_{\text{ref}}$, où $\Delta_{\text{ref}}$ caractérise dans notre cas le déphasage entre lesdites composantes TE et TM.

Ainsi, l'unité d'analyse électronique de référence 6a est apte à extraire de ce signal électrique $I_{\text{ref}}$, comprenant un terme interférométrique modulé en phase, le déphasage moyen $\Delta_{\text{ref}}$ entre les deux composantes transverse électrique TE et transverse magnétique TM de la portion de référence $S_{\text{référence}}$, et à extraire ledit terme d'amplitude $A_{\text{ref}}$. Cette méthode permet ainsi d'extraire ledit déphasage $\Delta_{\text{ref}}$ sans ambiguïté sur son intervalle de définition. A défaut d'autres méthodes d'extraction peuvent être envisagées pour des fonctions de modulation temporelles particulières, tel que des méthodes reposant sur des décalages de phase constants successifs, ou l'emploi d'une modulation rampe dite sérodyne. Une attention particulière doit être portée sur le fait que la modulation de courant entraine également une modulation temporelle de l'intensité du laser, ce qui entraine une modulation des termes d'intensité $E_{TE}^2$, $E_{TM}^2$ et $A_{ref}^2$ autour de leurs valeurs moyennes. Cette modulation supplémentaire peut fausser la mesure du déphasage si elle n'est pas prise en compte dans le traitement. Une détection synchrone généralisée, comme celle mentionnée, permet de traiter les signaux dont l'amplitude est également modulée temporellement et permet de s'affranchir de cette difficulté, idéalement en ajustant la profondeur de modulation de phase. A défaut, cette modulation sur lesdits termes d'intensité $E_{TE}^2$, $E_{TM}^2$ et $A_{ref}^2$ peut être négligée au prix d'une certaine erreur, ou bien l'intensité I$_{ref}$ mesurée peut être corrigée pour compenser cette modulation, connaissant la fonction de modulation utilisée. Le dispositif laser ainsi constitué est nommé D'.

En outre, par stabilisation du déphasage moyen $\Delta_{ref}$, l'unité d'analyse électronique de référence 6a peut fournir un coefficient de correction au moyen de modulation temporelle 2 de la source laser 1 de sorte à ajuster la modulation temporelle de la source laser 1 et à en stabiliser la longueur d'onde $\lambda$ moyenne. Ainsi, comme indiqué en trait pointillé sur la figure 1b, l'unité d'analyse électronique de référence 6a peut être reliée au moyen de modulation temporelle 2 de la source laser de sorte à constituer une boucle d'asservissement pour stabiliser le déphasage moyen $\Delta_{ref}$.

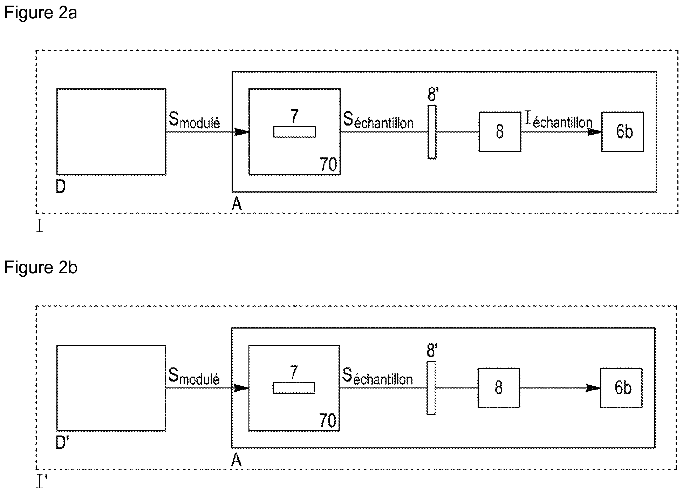

Les figures 2a et 2b illustrent deux interféromètres à polarisation, l'un, I, suivant la figure 2a, comprenant un dispositif laser D, et l'autre, I', suivant la figure 2b, comprenant un dispositif laser D'. Les interféromètres I et I' comprennent, dans une partie A en sortie des dispositifs laser respectivement D, ou D', une interface opto-mécanique 70 éclairée par un faisceau laser modulé temporellement en phase S$_{modulé}$ issu du dispositif laser D, ou D', et transmettant le faisceau laser modulé temporellement en phase S$_{modulé}$ vers un échantillon 7 dont on souhaite mesurer optiquement certaines caractéristiques par le déphasage relatif et éventuellement l'atténuation relative qu'il induit entre les deux composantes du champ. Le faisceau laser modulé temporellement en phase S$_{modulé}$ interagit alors avec l'échantillon 7 de façon à générer un faisceau de sortie S$_{échantillon}$ qui peut être transmis, réfléchi ou encore diffracté par l'échantillon. En sortie de l'interface opto-mécanique 70, le faisceau de sortie S$_{échantillon}$ traverse un polariseur d'analyse 8' à travers lequel les deux composantes TE et TM du faisceau de sortie S$_{échantillon}$ interfèrent. Suite à son passage à travers le polariseur d'analyse 8', le faisceau de sortie S$_{échantillon}$ est intercepté par un photo-détecteur d'analyse 8 qui délivre un signal électrique modulé I$_{échantillon}$ représentatif des interférences entre les deux composantes TE et TM du faisceau de sortie S$_{échantillon}$. Ce signal électrique modulé I$_{échantillon}$ est reçu et analysé par une unité d'analyse électronique 6b. En particulier, le signal électrique modulé I$_{échantillon}$ représentatif du faisceau de sortie S$_{échantillon}$, inclut un terme d'amplitude au carré $A_{échantillon}^2$ proportionnel au produit des amplitudes des deux composantes transverse électrique TE et transverse magnétique TM du faisceau de sortie S$_{échantillon}$, un terme de phase $\Delta_{échantillon}$, et une modulation temporelle de la phase, c'est-à-dire du déphasage entre le deux composantes de polarisation. Outre la modulation temporelle de phase, ledit déphasage inclut un incrément de déphasage optique $\Delta$ entre les deux composantes transverse électrique TE et transverse magnétique TM qui est induit par l'échantillon 7 lors de la réflexion, transmission ou diffraction résultant de l'interaction avec l'échantillon, produites par un ou plusieurs composants optiques tels que des lentilles, des miroirs, ou réseaux, utilisés notamment en vue de convoyer la lumière sur l'échantillon solide, gazeux ou liquide dans les conditions d'illumination souhaitées par l'utilisateur. Mathématiquement, on peut traduire cette propriété par :

$$I_{échantillon} \propto = I_0 + A_{échantillon}^2 cos(\Delta_{mod} + \Delta_{échantillon}).$$

En particulier aussi, l'unité d'analyse électronique de référence peut être configurée pour, par analyse dudit signal électrique I$_{échantillon}$, extraire ledit terme d'amplitude A$_{échantillon}$ et ledit terme de phase moyen $\Delta_{échantillon}$ entre les deux composantes transverse électrique TE et transverse magnétique TM du faisceau de sortie S$_{échantillon}$ permettant de déterminer des caractéristiques optiques dudit échantillon, spécifiquement par l'intermédiaire de l'incrément de déphasage optique $\Delta$, calculé, dans le cas où l'interféromètre est de type I', c'est-à-dire dans le cas où il comprend un dispositif laser avec bras de référence D', par : $\Delta=\Delta_{échantillon}-\Delta_{ref}$ à une constante additive près aisément déterminable, par exemple par calibration sur un échantillon au $\Delta$ connu.

L'interféromètre à polarisation de type I' illustré à la figure 2b peut en outre être utilisé comme ellipsomètre fonctionnant en réflexion ou en transmission. Dans ces deux cas, un échantillon 7 est placé au niveau de l'interface 70 de l'interféromètre à polarisation I'. Le faisceau laser modulé en phase S$_{modulé}$, incident sur l'échantillon 7, se réfléchit spéculairement à la surface de celui-ci, ou bien est transmis spéculairement par celui-ci pour une transmission, et se propage en un faisceau de sortie S$_{échantillon}$ intercepté par le polariseur d'analyse 8' et le photo-détecteur d'analyse 8. L'unité d'analyse électronique 6b permet, comme expliqué plus haut, d'extraire le paramètre ellipsométrique $\Delta_{ellipsométrie}$, par la formule $\Delta_{ellipsométrie} + \Delta_{échantillon} - \Delta_{ref}$ à une constante additive près.

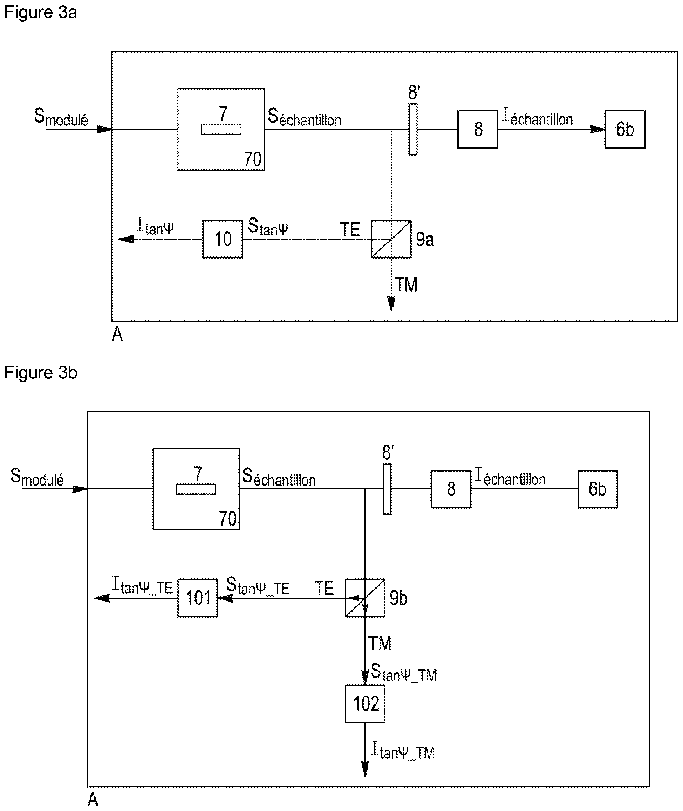

La figure 3a illustre une première variante de l'ellipsomètre présenté à la figure 2b, dans laquelle la partie A comprend des éléments supplémentaires décrits ci-après. En effet, dans cette première variante, l'ellipsomètre précédemment décrit comprend en outre une première voie de détection supplémentaire permettant de déterminer un paramètre ellipsométrique tan$\Psi$ d'un échantillon 7. Cette voie supplémentaire comprend un premier dispositif séparateur de faisceau sélectif en polarisation 9a en amont du polariseur d'analyse 8', qui permet de prélever une portion du faisceau de sortie S$_{échantillon}$ et de filtrer une des deux composantes transverse électrique TE ou transverse magnétique TM de cette portion du faisceau de sortie S$_{échantillon}$ sous la forme d'un faisceau S$_{tan\Psi}$ appelé portion polarisée. Cette portion polarisée S$_{tan\Psi}$ est interceptée par un photo-détecteur pour ellipsométrie complète 10 qui génère un signal électrique I$_{tan\Psi}$ caractéristique de l'intensité lumineuse de la portion polarisée. Le paramètre ellipsométrique tan$\Psi$ de l'échantillon est alors déterminé à l'aide des quantités A$_{échantillon}$ et I$_{tan\Psi}$ issus respectivement de l'analyse du signal I$_{échantillon}$ issu du photo-détecteur d'analyse 8 et du photo-détecteur pour ellipsométrie complète 10.

En effet, le paramètre tan$\Psi$ s'obtient, comme classiquement en ellipsométrie par la formule :

$$tan\psi = \left|\frac{r_{TM}}{r_{TE}}\right|,$$

où r$_{TM}$ et r$_{TE}$ sont les coefficients de réflexion de l'échantillon portés par les composantes TM et TE du faisceau de sortie S$_{échantillon}$. Ainsi, le paramètre tan$\Psi$ peut être obtenu, suivant la configuration expérimentale utilisée, soit par son carré donné par l'équation :

$$(tan\psi)^2 \propto \frac{A^2_{échantillon}}{I_{tan\Psi}},$$

si la composante TE est récupérée par la première voie de détection supplémentaire,

soit par l'équation :

$$(tan\psi)^2 \propto \frac{I_{tan\Psi}}{A^2_{échantillon}},$$

si la composante TM est récupérée par la première voie de détection supplémentaire.

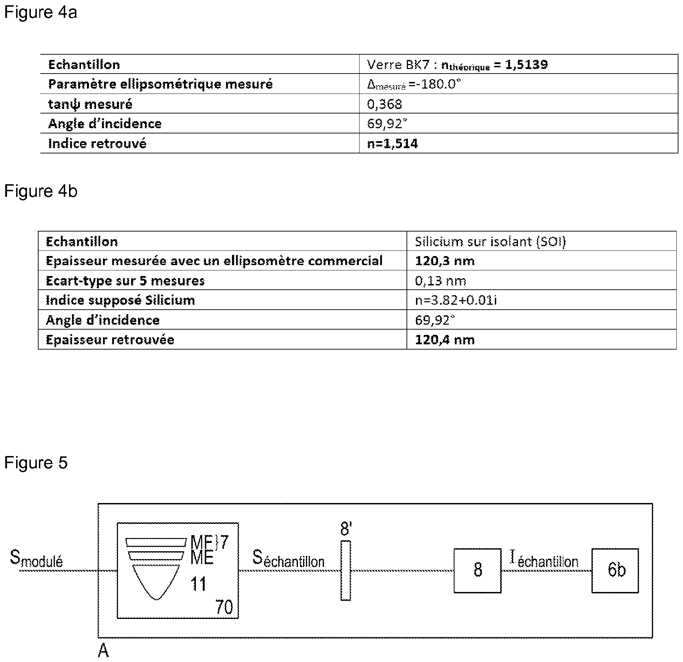

La figure 4 présente des tableaux de mesures d'indice et d'épaisseur d'échantillons de verre et de silice sur silicium obtenues avec un ellipsomètre du type de la figure 3a.

La figure 3b illustre une deuxième variante de l'ellipsomètre présenté à la figure 2b, dans laquelle la partie A comprend des éléments supplémentaires décrits ci-après. En effet, dans cette deuxième variante, l'ellipsomètre précédemment décrit à la figure 2b comprend en outre une deuxième voie de détection supplémentaire permettant de déterminer un paramètre ellipsométrique tan$\Psi$ d'un échantillon 7. Cette voie de détection supplémentaire comprend un deuxième dispositif séparateur de faisceau sélectif en polarisation 9b en amont du polariseur d'analyse 8', qui permet de prélever une portion du faisceau de sortie S$_{échantillon}$ et de sélectionner les deux composantes transverse électrique TE et transverse magnétique TM de cette portion du faisceau de sortie S$_{échantillon}$ sous la forme de deux faisceaux S$_{tan\Psi\_TE}$ et S$_{tan\Psi\_TM}$ appelés respectivement portion polarisée TE et portion polarisée TM et se propageant dans deux directions différentes. La portion polarisée TE et la portion polarisée TM sont reçues chacune respectivement par un photo-détecteur 101 et un photo-détecteur 102, appelés respectivement photo-détecteur TE et photo-détecteur TM. Le paramètre ellipsométrique tan$\Psi$ de l'échantillon est alors déterminé à l'aide des signaux électriques I$_{tan\Psi\_TE}$ et I$_{tan\Psi\_TM}$ issus des photo-détecteur TE 101 et photo-détecteur TM 102.

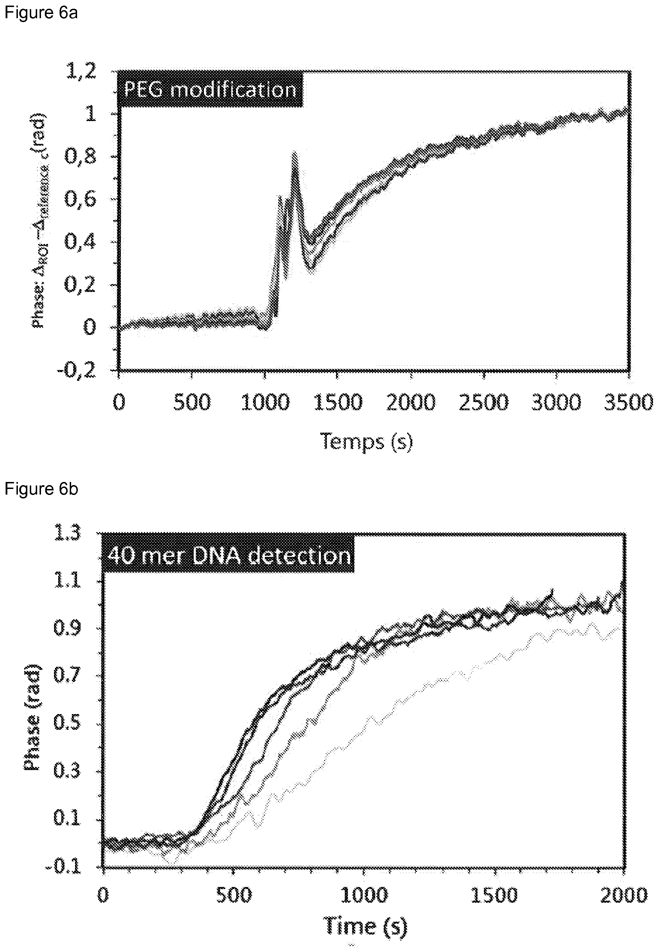

La figure 5 illustre schématiquement un biocapteur de type système de détection à résonance de plasmon de surface, comprenant un dispositif laser D et apte à déterminer des caractéristiques d'un échantillon constitué d'un résonateur optique ME en interaction avec une couche microfluidique MF, correspondant au milieu biologique ou biochimique à analyser 7. Ce biocapteur comprend dans une partie A en sortie du dispositif laser D (à l'image de l'interféromètre I décrit plus haut), et recevant un faisceau laser modulé temporellement en phase S$_{modulé}$, une biopuce amovible 11 pouvant comprendre un prisme 110 ou plus généralement une optique de couplage à même d'exciter optiquement l'échantillon formé par le résonateur optique ME en interaction avec la couche microfluidique MF représentant le milieu 7 à analyser. Cette biopuce est positionnée au niveau d'une interface 70 et intercepte le faisceau laser modulé temporellement en phase S$_{modulé}$. Celui-ci excite une onde de résonance de plasmon de surface à la surface de la couche métallique ME de la biopuce, qui interagit avec le milieu à analyser 7 au niveau de l'interface avec la couche microfluidique avant d'être réfléchie produisant un faisceau S$_{échantillon}$. Le faisceau de sortie S$_{échantillon}$ est intercepté par un polariseur d'analyse 8' suivi d'un photo-détecteur d'analyse 8 délivrant un signal électrique I$_{échantillon}$. Une unité d'analyse électronique 6b reliée au photo-détecteur d'analyse 8 permet, comme expliqué plus haut, de déterminer des caractéristiques dudit échantillon 7. Les figures 6a et 6b illustrent le type de mesures pouvant être obtenues avec un biocapteur tel que décrit précédemment et illustré sur la figure 5. Ces figures seront décrites plus en détail dans les exemples présentés ci-après.

EXEMPLES

EXEMPLE 1 : Mise en oeuvre d'un dispositif laser

On réalise un dispositif laser tel qu'illustré sur les figures 1a à 1b pour mettre en oeuvre un interféromètre à polarisation pouvant être appliqué à une mesure ellipsométrique « complète » ou la détection SPR sensible à la phase, et permettant de déterminer des caractéristiques d'un échantillon 7 par exemple de type couches minces ou multicouches comme du verre traité, ou des échantillons utilisés en micro-électronique, à partir des éléments suivants :

- source laser monomode longitudinal 1 : VCSEL référencé "VC670M-TO46GL" à 670 nm, d'accordabilité de l'ordre de 0.2nm/mA ;

- moyen de modulation temporelle électronique de la source laser 2 : modulation sinusoïdale du courant d'injection du VCSEL précité, de valeur moyenne $i_0$ suffisante par exemple égale à 4mA et de fréquence préférablement élevée pour réduire les bruits, jusqu'à 100kHz ou plus (suivant les capacités de l'électronique), exprimée par la relation $i(t)=i_0+\beta\sin(\Omega t)$;

- élément retardateur de phase passif 3 : cristal de vanadate d'yttrium YVO4 de biréfringence égale à 0.22 et de longueur 10 mm ;

- séparateur de faisceau de référence 4 : lame séparatrice telle que la référence BSS04 (Thorlabs), ou cube séparateur ;

- polariseur de référence 5' : polariseur adapté à la longueur d'onde utilisée tel que LPVISE050-A (Thorlabs) ;

- photo-détecteur de référence 5 : photodétecteur adapté à la longueur d'onde utilisée et les fréquences de modulation employées, par exemple une photodiode en silicium pour le visible comme par exemple la référence PDA36A-EC (THORLABS) ;

- unité d'analyse électronique de référence 6a : carte d'acquisition électronique par exemple la référence NI USB-6363 (National Instrument).

La modulation temporelle est typiquement réalisée par une modulation du courant d'injection de la source laser monomode longitudinale utilisée. La modulation est préférentiellement sinusoïdale mais d'autres modulations peuvent être utilisées en vue de réaliser une détection interférométrique à décalage de phase discrète ou continue. Dans le cas sinusoïdal, la modulation du courant d'injection i(t) est, comme mentionnée, du type : $i_0+\beta\sin(\Omega t)$. Dans le cas du type de VCSEL précité, $i_0$ est typiquement de l'ordre de 4 mA. La modulation en courant induit une modulation de puissance optique approximativement égale à: $P(t)=P_0+\gamma\sin(\Omega t)=P_0 (1+\mu\sin(\Omega t))$, où $P_0$ est la composante DC de puissance, et $\mu*P_0$, l'amplitude AC de la modulation, $\Omega$ est la pulsation de la modulation. Cette modulation de puissance induit une modulation de longueur d'onde approximativement égale à $\lambda(t)=\lambda_0+\delta\sin(\Omega t)$, où $\lambda_0$ est la longueur d'onde moyenne et $\delta$ est la profondeur de modulation en longueur d'onde. En présence d'une telle modulation (de courant, mais aussi depuissance et longueur d'onde), une modulation de phase est créée entre les composantes TE et TM dès lors que le faisceau traverse le cristal biréfringent YVO4 susmentionné. La modulation de phase induite s'écrit: $a\sin(\Omega t)$ dans le cas sinusoïdal, avec la profondeur de modulation en phase donnée par :

$$a = \frac{4\pi\Delta l\delta}{\lambda_0^2},$$

où $\Delta l$ est la différence de chemin optique entre les deux composantes du champ au sein de l'élément retardateur 3. En pratique, il est intéressant de travailler avec une modulation de phase a= 3.83 rad comme expliqué dans un autre cadre par Vaillant et al. dans « An unbalanced interferometer insensitive to wavelength drift ». Sensors and Actuators A: Physical, 268, 188-192. Dans la référence ci-dessus, ce choix de profondeur de modulation de phase permet d'analyser plus simplement le signal interférométrique résultant et d'extraire l'information d'amplitude $A_{\text{échantillon}}$ et le terme de

phase recherché $\Delta_{\text{échantillon}}$ simplement.

Dans notre cas, pour obtenir la modulation de phase temporelle, la biréfringence $(n_e-n_o)$ et la longueur L du cristal YVO4 sont telles que la différence de chemin optique donnée par le produit $L(n_e-n_o)$ est au minimum de l'ordre de grandeur du millimètre, ce qui correspond à un déphasage cumulé entre la composante TM et la composante TE de l'ordre de 10 000 radians pour de la lumière visible. Cette différence de chemin optique cumulée est réalisée avec les composants précédemment mentionnés.

EXEMPLE 2 : Mesure d'un paramètre $\Delta_{\text{ellipsométrie}}$

On réalise un ellipsomètre tel que décrit précédemment et illustré à la figure 2b pour déterminer un paramètre $\Delta_{\text{ellipsométrie}}$, à partir du dispositif laser décrit dans l'exemple 1.

Pour mettre en oeuvre l'ellipsomètre précité, on utilise en outre :

- une interface opto-mécanique 70 configurée pour transmettre le faisceau laser modulé temporellement en phase $S_{\text{modulé}}$ sortant du dispositif laser selon l'exemple 1 vers un échantillon 7 de sorte que le faisceau laser modulé temporellement en phase $S_{\text{modulé}}$ interagisse avec l'échantillon de façon à générer un faisceau de sortie $S_{\text{échantillon}}$;

- un polariseur d'analyse 8' : polariseur LPVISE050-A (Thorlabs) ;

- un photo-détecteur d'analyse 8 : photodiode en silicium par exemple la référence PDA36A-EC (THORLABS) ;

- une unité d'analyse électronique 6b : carte d'acquisition électronique par exemple la référence NI USB-6363 (National Instrument).

Le paramètre ellipsométrique $\Delta_{\text{ellipsométrie}}$ est obtenu par la formule $\Delta_{\text{ellipsométrie}}=\Delta_{\text{échantillon}}-\Delta_{\text{ref}}$ à une constante additive près, avec $\Delta_{\text{échantillon}}$ le paramètre de phase extrait du signal électrique $I_{\text{échantillon}}$ issu du photo-détecteur d'analyse 8, et correspondant au déphasage entre les composantes TE et TM du faisceau de sortie $S_{\text{échantillon}}$ induit par l'échantillon.

EXEMPLE 3 : Mesures ellipsométriques d'indices et d'épaisseurs d'échantillons de multicouches de type couches minces

On réalise un ellipsomètre comme illustré à la figure 3a pour déterminer des paramètres $\Delta_{\text{ellipsométrie}}$ et $\tan\Psi$, à partir de l'ellipsomètre décrit dans l'exemple 2, et comprenant en outre :

- un premier dispositif séparateur de faisceau sélectif en polarisation 9a, séparateur simple tel BSS04 (Thorlabs) suivi de polariseurs tels LPVISE050-A (Thorlabs) ;

- un photo-détecteur pour ellipsométrie complète 10.

Le paramètre ellipsométrique $\Delta_{\text{ellipsométrie}}$ est obtenu comme dans l'exemple 2. Le paramètre $(\tan_\Psi)^2$ peut être

obtenu, suivant la configuration expérimentale utilisée, soit par l'équation $(tan\psi)^2 \propto \frac{A^2_{\text{échantillon}}}{I_{tan\Psi}}$, si la composante TE est récupérée par la première voie de détection supplémentaire, ou l'inverse si la composante TM est récupérée par la première voie de détection supplémentaire. En pratique, le coefficient de proportionnalité entre $(\tan\Psi)^2$ et $A^2_{\text{échantillon}}/I_{\tan\Psi}$ peut être prédéterminé simplement par une expérience de calibration sur un échantillon connu. Dans cet exemple, le coefficient de proportionnalité est préalablement déterminé en mesurant le paramètre $\tan\Psi$ sur un échantillon connu.

A partir des paramètres $\Delta_{\text{ellipsométrie}}$ et $\tan\Psi$, il est possible de déterminer, comme classiquement en ellipsométrie, l'indice optique complexe ou l'épaisseur de la couche mince connue ou d'autre paramètres inconnus lié par exemple à la rugosité. La figure 4 illustre un ensemble de résultats expérimentaux réalisés avec l'ellipsomètre précédemment décrit.

EXEMPLE 4 : Mesures ellipsométriques d'indices et d'épaisseurs d'échantillons de type couches minces ou empilements multicouches

On réalise un ellipsomètre comme illustré à la figure 3b pour déterminer des paramètres $\Delta_{\text{ellipsométrie}}$ et $\tan\Psi$,

à partir de l'ellipsomètre décrit dans l'exemple 2, et comprenant en outre :

- un deuxième dispositif séparateur de faisceau sélectif en polarisation 9b : séparateur simple tel BSS04 (Thorlabs) suivi de polariseurs tels LPVISE050-A (Thorlabs), ou séparateurs simples fonctionnant en incidence Brewsterienne ;

- deux photo-détecteurs 101 et 102 : photodiodes en silicium, éventuellement amplifiées, par exemple la référence PDA36A-EC (THORLABS).

Le paramètre ellipsométrique $\Delta_{ellipsométrie}$ est obtenu comme dans les exemples 2 et 3. Comme décrit plus haut, le paramètre $\tan\Psi$ est directement obtenu par son carré :

$$(tan\psi)^2 \propto \frac{I_{tan\Psi\_TM}}{I_{tan\Psi\_TE}} \qquad ,$$

avec $I_{tan\Psi\_TE}$ et $I_{tan\Psi\_TM}$ les signaux issus des photo-détecteur TE et photo-détecteur TM. Le coefficient de proportionnalité est égal à l'unité si les faisceaux sont partagés en proportions identiques. En pratique le coefficient peut être prédéterminé simplement par une expérience de calibration, par exemple sur un échantillon connu. A partir des paramètres $\Delta_{ellipsométrie}$ et $\tan\Psi$, il est possible de déterminer, comme classiquement en ellipsométrie, l'indice complexe et l'épaisseur de couches au sein de l'échantillon mesuré.

EXEMPLE 5 : Mesures de type résonance de plasmon de surface et détection de PEG thiolé (poly-ethylene glycol-SH)

On réalise un biocapteur tel qu'illustré sur la figure 5 pour application à la détection de type résonance de plasmon de surface permettant de mesurer des paramètres d'un échantillon 7 afin de monitorer ici le dépôt de PEG thiolé sur celui-ci. L'échantillon est constitué d'un résonateur optique (ME) formé ici d'une couche d'or de 45nm environ mis en interaction avec la solution contenant le PEG thiolé (poly-ethylene glycol-SH) présente au sein de la couche microfluidique. Ce biocapteur illustré sur la figure 5 est réalisé à partir du dispositif laser décrit dans l'exemple 1, en y ajoutant comme illustré sur la figure 5 :

- une interface opto-mécanique 70 : support ;

- un polariseur d'analyse 8' : polariseur LPVISE050-A (Thorlabs) ;

- un photo-détecteur d'analyse 8 : photodiode en silicium par exemple la référence PDA36A-EC (THORLABS) ;

- une unité d'analyse électronique 6b : carte d'acquisition électronique par exemple la référence NI USB-6363 (National Instrument) ;

- la biopuce préférablement amovible 11 disposée sur l'interface 70 et comprenant un prisme 110 sur lequel est déposée une couche métallique ME d'or (d'épaisseur 45nm) apte à recevoir la couche PEG thiolé constituant l'échantillon à analyser.

Dans ce cas précis, le photo-détecteur d'analyse 8 est un imageur permettant une mesure multipoints. Le biocapteur est utilisé en configuration dite de Kretschmann via le prisme (110). Le paramètre $\Delta=\Delta_{échantillon}-\Delta_{ref}$ qui peut être déterminé grâce à l'interféromètre à polarisation du biocapteur tel que décrit précédemment n'est en général pas accessible avec d'autres types de dispositifs de mesure SPR. La figure 6a illustre la mesure de la fonctionnalisation de la couche d'or en contact avec la couche microfluidique de PEG thiolé. Ce type de mesure permet d'obtenir des informations optogéométriques sur la couche déposée et ici en particulier de connaître le temps au bout duquel la réaction n'évolue plus que faiblement (e.g. 3500 secondes).

EXEMPLE 6 : Mesures de type résonance de plasmon de surface et détection de différentes quantités d'ADN 40 mer

La figure 6b illustre des mesures visant à détecter différentes quantité d'ADN se liant à la surface (sensorgrammes en phase), via les variations du paramètre $\Delta$ au cours du temps au sein des différentes régions d'intérêt. La comparaison avec les signaux de références permet de s'affranchir de fluctuations des paramètres d'amplitude et de phase non liées à la cible elle-même, tel que des variations environnementales comme des variations de température au niveau de la puce elle-même. La couche microfluidique utilisée est composée ici de brins d'ADN complémentaires de 40 mer codons. Les courbes de différents niveaux de couleur (noir à gris clair) présentent ainsi une cinétique de variation caractéristique des concentrations analysées, ici de 25 nM à 500 nM. Les courbes observées suivent un processus d'adsorption classique de type Langmuir isotherme.

Il est à noter que les mesures de type SPR ci-dessus, effectuées avec un dispositif laser selon l'exemple 1, peuvent être également réalisées à l'aide d'un dispositif laser tel que proposé dans la présente demande possédant d'autres caractéristiques, par exemple, avec une source laser fonctionnant à une toute autre longueur d'onde, comme dans l'infrarouge moyen ou le proche infrarouge, par exemple avec un VCSEL fonctionnant à une longueur d'onde de 850 mm environ avec la même modulation de phase, soit 3.84rad, et en adaptant la modulation de courant en mA pour atteindre cette modulation de phase, ainsi que les composants du système pour opérer à cette longueur d'onde.

D'autres modes de réalisation peuvent être envisagés. Par exemple, un autre mode de réalisation peut comprendre des mesures multi-angles, où, dans les deux cas d'applications à l'ellipsométrie ou la détection par résonance de plasmon de surface, des mesures selon plusieurs angles d'incidence sont effectuées, ou inversement le faisceau en sortie de l'échantillon mesuré est séparé après interaction avec l'échantillon selon plusieurs angles différents. Dans le cas de la pluralité d'angles d'incidence, une lentille cylindrique peut par exemple être placée en amont de l'interface recevant les échantillons à tester pour obtenir un faisceau focalisé dans le plan d'incidence, donnant ainsi une pluralité d'angles d'incidence illuminant l'échantillon, celui-ci réfléchissant le faisceau étendu reçu selon plusieurs directions capté par un détecteur linéaire (de type barrette de diodes par exemple).

Egalement, comme évoqué dans l'exemple 6, les photo-détecteurs d'analyse 8, photo-détecteur pour ellipsométrie complète 10, et photo-détecteur TE et photo-détecteur TM 101 et 102 peuvent être des capteurs bidimensionnels permettant d'imager des échantillons à mesurer et d'obtenir des cartographies bidimensionnelles de caractéristiques de ces échantillons. Dans ce cas, tous types de capteurs bidimensionnels peuvent être utilisés, tels que des capteurs CCD ou CMOS, ou des photodétecteurs ayant un nombre réduit de zones de détection comme des photodiodes à quadrant pouvant également aider au centrage du faisceau.

Egalement, des mesures ellipsométriques en transmission peuvent être réalisées dans le cas d'échantillon suffisamment transparents. Une pluralité de sources optiques laser peuvent également être employées pour étendre le domaine spectral d'analyse. Egalement, l'analyse ellipsométrique peut être étendue pour obtenir des informations complémentaires sur l'échantillon à partir des paramètres ellipsométriques déterminés à partir de modèle pouvant prendre en compte notamment la densité ou la rugosité d'une couche.

Egalement, le dispositif SPR pouvant intégrer une mesure ellipsométrique, ce dernier peut être utilisé pour déterminer les caractéristiques des couches composant la biopuce, par exemple l'épaisseur du dépôt d'or, ou l'épaisseur (ou la densité) d'une couche de fonctionnalisation, ou encore les couches moléculaires issues de l'analyte traversant la couche microfluidique s'accrochant à la surface. Ainsi la biopuce peut être préparée pour la mesure d'une espèce biochimique quelconque (pathogènes, protéines, bactéries, biomarqueurs) en s'aidant du dispositif de mesure ellipsométrique à chaque étape du processus de fonctionnalisation, qui est typiquement réalisée sur les biopuces SPR pour permettre la détection d'une cible notamment à l'aide d'anticorps, d'ADN ou d'aptamers.

Les exemples d'interfaces optomécaniques 70 donnés dans cette description ne sont pas limitatifs. Ainsi, en plus d'un simple support comme à l'exemple 5, ou d'un prisme de couplage pourvu ou non d'élément résonant comme à l'exemple 5, des réseaux de couplage ou des lentilles pourraient être utilisés pour exciter optiquement une résonance de l'échantillon. En particulier, les dispositifs SPR nécessitent typiquement un élément de couplage comme dans les exemples donnés dans cette description. L'élément de couplage permet d'obtenir, le cas échéant, une pluralité d'angles d'excitation. L'excitation privilégiée des dispositifs SPR est une excitation sous un angle supercritique connu sous l'appellation de configuration Kretschmann. Ainsi le rôle essentiel de l'interface opto-mécanique est de définir le ou les angles d'incidence et plus généralement les conditions d'éclairage sur l'échantillon.

## Revendications

1. Dispositif laser (D) pour interférométrie à polarisation adapté pour délivrer un faisceau laser modulé temporellement en phase ($S_{modulé}$) et comprenant :

   - une source laser monomode longitudinal (1), alimentée par un courant électrique d'alimentation, et configurée pour délivrer un faisceau laser source ($S_{source}$) polarisé de longueur d'onde ($\lambda$), comprenant deux composantes de polarisation rectilignes orthogonales non nulles, nommées respectivement transverse électrique, TE, et transverse magnétique, TM,
   - un moyen de modulation temporelle électronique de la source laser (2) configuré pour piloter une modulation temporelle de la longueur d'onde du faisceau laser source ($S_{source}$)
   - un élément retardateur de phase passif produisant deux chemins de longueurs optiques différentes pour lesdites composantes de polarisation TE et TM (3) configuré pour recevoir le faisceau laser source ($S_{source}$) et introduire, du fait de la modulation de longueur d'onde du faisceau laser source ($S_{source}$), un déphasage temporellement modulé entre lesdites composantes TE et TM pour fournir ledit faisceau laser modulé temporellement en phase ($S_{modulé}$) dans lequel l'élément retardateur de phase passif comprend un composant présentant une biréfringence et est configuré pour créer un chemin géométrique commun pour les composantes TE et TM.

**2.** Dispositif laser (D) selon la revendication 1, dans lequel la source laser (1) est un laser à semi-conducteur modulable en longueur d'onde par le courant électrique d'alimentation du laser sur une plage d'accordabilité inférieure à un millième de la longueur d'onde.

**3.** Dispositif laser (D) selon la revendication 2 dans lequel la source de type laser à semi-conducteur (1) est une diode laser à cavité verticale émettant par la surface VCSEL.

**4.** Dispositif laser (D) selon la revendication 3 dans lequel l'élément retardateur de phase (3) comprend un cristal biréfringent ayant un axe optique orienté selon l'une des dites composantes de polarisation TE ou TM du faisceau laser source ($S_{source}$).

**5.** Dispositif laser (D') selon l'une des revendications 1 à 4 comprenant en outre :

- un séparateur de faisceau de référence (4) en sortie de l'élément retardateur de phase (3) destiné à séparer le faisceau en au moins deux parties ($S_{référence}$) et ($S_{modulé}$), la première partie ($S_{référence}$) étant une portion de référence du faisceau laser modulé temporellement en phase ($S_{modulé}$), et ledit séparateur de faisceau étant configuré pour propager la portion de référence dans une direction différente de celle du faisceau laser modulé temporellement en phase ($S_{modulé}$)
- un photo-détecteur de référence (5) comprenant une entrée destinée à recevoir par l'intermédiaire d'un polariseur de référence (5') ladite portion de référence ($S_{référence}$), et ledit photo-détecteur de référence (5) étant configuré pour générer un premier signal interférométrique, sous forme d'un premier signal électrique modulé ($I_{ref}$) représentatif de ladite portion de référence ($S_{référence}$)
- une unité d'analyse électronique de référence (6a) configurée pour recevoir et analyser ledit signal électrique ($I_{ref}$) pour extraire un déphasage moyen ($\Delta_{ref}$) entre les deux composantes orthogonales transverse électrique TE et transverse magnétique TM de la portion de référence ($S_{référence}$),

le signal électrique modulé ($I_{ref}$) représentatif de ladite portion de référence ($S_{référence}$) incluant un terme d'amplitude ($A_{ref}$) proportionnel au produit des amplitudes des deux composantes transverse électrique TE et transverse magnétique TM et un terme de phase,
l'unité d'analyse électronique de référence (6a) étant configurée pour, par analyse dudit signal électrique($I_{ref}$), en déduire le déphasage moyen ($\Delta_{ref}$) entre les deux composantes transverse électrique TE et transverse magnétique TM de la portion de référence ($S_{référence}$), et extraire ledit terme d'amplitude ($A_{ref}$), et l'unité d'analyse électronique de référence (6a) étant en outre configurée pour fournir un coefficient de correction au moyen de modulation temporelle de la source laser (2) de sorte à ajuster la modulation temporelle de la source laser (1) et à en stabiliser la longueur d'onde λ moyenne par stabilisation du déphasage moyen ($\Delta_{ref}$).

**6.** Dispositif laser (D') selon la revendication 5 dans lequel ladite unité d'analyse électronique de référence (6a) est reliée au moyen de modulation temporelle de la source laser (2) de sorte à constituer une boucle d'asservissement pour stabiliser le déphasage moyen ($\Delta_{ref}$).

**7.** Interféromètre à polarisation I configuré pour mesurer des caractéristiques d'un échantillon (7), comprenant :

- un dispositif laser (D) ou (D') selon l'une quelconque des revendications 1 à 6, adapté pour délivrer un faisceau laser modulé temporellement en phase ($S_{modulé}$) ;
- une interface opto-mécanique (70) :

  - un photo-détecteur d'analyse (8) et un polariseur d'analyse (8') ;
  - une unité d'analyse électronique (6b) ;

dans lequel

ladite interface opto-mécanique (70) étant un simple support de l'échantillon ou un système de couplage optique pouvant inclure différentes optiques configuré pour recevoir et transmettre le faisceau laser modulé temporellement en phase ($S_{modulé}$) vers l'échantillon (7) de façon à générer un faisceau de sortie ($S_{échantillon}$), le photo-détecteur d'analyse (8) comprend une entrée configurée pour recevoir par l'intermédiaire du polariseur d'analyse (8') ledit faisceau de sortie ($S_{échantillon}$), et ledit le photo-détecteur d'analyse (8) étant configuré pour générer un deuxième signal interférométrique, sous forme d'un deuxième signal électrique modulé ($I_{échantillon}$),

ladite unité d'analyse électronique (6b) est connectée au photo-détecteur d'analyse (8) et est configurée pour recevoir et analyser ledit signal électrique modulé ($I_{échantillon}$) pour déterminer des caractéristiques dudit échantillon (7).

8. Interféromètre à polarisation I suivant la revendication 7 configuré pour déterminer des caractéristiques optiques dudit échantillon (7) dans lequel :- l'unité d'analyse électronique (6b) est configurée pour, par analyse dudit signal électrique ($I_{échantillon}$), extraire un terme d'amplitude ($A_{échantillon}$) et un terme de phase moyen ($\Delta_{échantillon}$) entre les deux composantes transverse électrique TE et transverse magnétique TM du faisceau de sortie ($S_{échantillon}$) permettant de déterminer les caractéristiques optiques dudit échantillon (7), et,

lorsque l'interféromètre à polarisation comprend :

- un séparateur de faisceau de référence (4) en sortie de l'élément retardateur de phase (3) configuré pour séparer le faisceau en au moins deux parties ($S_{référence}$) et ($S_{modulé}$), ladite partie ($S_{référence}$) étant une portion de référence du faisceau laser modulé temporellement en phase ($S_{modulé}$), et étant configurée pour se propager dans une direction différente de celle du faisceau laser modulé temporellement en phase ($S_{modulé}$),
- un photo-détecteur de référence (5) comprenant une entrée configurée pour recevoir par l'intermédiaire d'un polariseur de référence (5') ladite portion de référence ($S_{référence}$), et ledit le photo-détecteur de référence (5) étant configuré pour générer un premier signal interférométrique, sous forme d'un premier signal électrique modulé ($I_{ref}$) représentatif de ladite portion de référence ($S_{référence}$),
- une unité d'analyse électronique de référence (6a) configurée pour recevoir et analyser ledit signal électrique ($I_{ref}$),

ladite unité d'analyse électronique de référence (6a) est de plus configurée pour extraire un déphasage moyen ($\Delta_{ref}$) entre les deux composantes transverse électrique TE et transverse magnétique TM de la portion de référence ($S_{référence}$), de manière à calculer, à une constante additive près, un incrément de déphasage optique ($\Delta$) induit par l'échantillon par la formule $\Delta = \Delta_{échantillon} - \Delta_{ref}$.

9. Ellipsomètre configuré pour fonctionner en réflexion, et configuré pour déterminer un paramètre ellipsométrique ($\Delta_{ellipsométrie}$) d'un échantillon (7) comprenant un interféromètre à polarisation I selon la revendication 8 et dans lequel :

l'interface opto-mécanique (70) de l'interféromètre à polarisation (I) est apte à recevoir l'échantillon (7), et

lorsque le dispositif laser est un dispositif laser D', comprenant :

- un séparateur de faisceau de référence (4) en sortie de l'élément retardateur de phase (3) configuré pour séparer le faisceau en au moins deux parties ($S_{référence}$) et ($S_{modulé}$), ladite partie ($S_{référence}$) étant une portion de référence du faisceau laser modulé temporellement en phase ($S_{modulé}$), et étant configurée pour se propager dans une direction différente de celle du faisceau laser modulé temporellement en phase ($S_{modulé}$),
- un photo-détecteur de référence (5) comprenant une entrée configurée pour recevoir par l'intermédiaire d'un polariseur de référence (5') ladite portion de référence ($S_{référence}$), et ledit le photo-détecteur de référence (5) étant configuré pour générer un premier signal interférométrique, sous forme d'un premier signal électrique modulé ($I_{ref}$) représentatif de ladite portion de référence ($S_{référence}$),
- une unité d'analyse électronique de référence (6a) configurée pour recevoir et analyser ledit signal électrique ($I_{ref}$), alors

l'unité d'analyse électronique de référence (6a) est configurée, par analyse dudit signal électrique ($I_{ref}$), pour extraire un déphasage moyen ($\Delta_{ref}$) entre les deux composantes transverse électrique TE et transverse magnétique TM de la portion de référence ($S_{référence}$), pour obtenir le paramètre ellipsométrique ($\Delta_{ellipsométrie}$) par

la formule $(\Delta_{ellipsométrie}) = (\Delta_{échantillon}) - (\Delta_{ref})$ à une constante additive près.

10. Ellipsomètre selon la revendication 9, configuré pour déterminer un paramètre ellipsométrique $(tan\Psi)$ d'un échantillon (7) et comprenant une première voie de détection supplémentaire, ladite première voie de détection supplémentaire comprenant:

- un premier dispositif séparateur de faisceau sélectif en polarisation (9a), configuré pour prélever une portion du faisceau de sortie $(S_{échantillon})$ et sélectionner une des deux composantes transverse électrique TE et transverse magnétique TM du faisceau de sortie $(S_{échantillon})$ sous la forme d'un faisceau $(S_{tan\Psi})$ appelé portion polarisée
- un photo-détecteur pour ellipsométrie complète (10) configuré pour recevoir ladite portion polarisée $(S_{tan\Psi})$ et générer un signal électrique $(I_{tan\Psi})$ caractéristique de l'intensité lumineuse de la portion polarisée,

où ladite première voie de détection supplémentaire est configurée pour déterminer le paramètre ellipsométrique $(tan\Psi)$ de l'échantillon à l'aide des signaux électriques $(I_{échantillon})$ et $(It_{an\Psi})$ issus respectivement du photo-détecteur d'analyse (8) et du photo-détecteur pour ellipsométrie complète (10).

11. Ellipsomètre selon la revendication 9, configuré pour déterminer un paramètre ellipsométrique $(tan\Psi)$ d'un échantillon (7) et comprenant en outre une deuxième voie de détection supplémentaire, ladite deuxième voie de détection supplémentaire comprenant :

- un deuxième dispositif séparateur de faisceau sélectif en polarisation (9b) configuré pour prélever une portion du faisceau de sortie $(S_{échantillon})$ et sélectionner les deux composantes transverse électrique TE et transverse magnétique TM du faisceau de sortie $(S_{échantillon})$ sous la forme de deux faisceaux $(S_{tan\Psi\_TE})$ et $(S_{tan\Psi\_TM})$ appelés respectivement portion polarisée TE et portion polarisée TM
- deux photo-détecteurs (101) et (102) appelés photo-détecteur TE et photo-détecteur TM configurés pour recevoir respectivement lesdites portion polarisée TE $(S_{tan\Psi\_TE})$ et portion polarisée TM $(S_{tan\Psi\_TM})$ et pour générer respectivement un signal électrique $(I_{tan\Psi\_TE})$ caractéristique de l'intensité lumineuse de la portion polarisée TE $(S_{tan\Psi\_TE})$ et un signal électrique $(I_{tan\Psi\_TM})$ caractéristique de l'intensité lumineuse de la portion polarisée TM $(S_{tan\Psi\_TM})$, où la deuxième voie de détection supplémentaire est configurée pour déterminer le paramètre ellipsométrique $(tan\Psi)$ de l'échantillon à l'aide des signaux électriques $(I_{tan\Psi\_TE})$ et $(I_{tan\Psi\_TM})$ issus des photo-détecteur TE (101) et photo-détecteur TM (102).

12. Biocapteur de type système de détection à résonance de plasmon de surface configuré pour déterminer des caractéristiques d'un échantillon (7) constitué d'une couche microfluidique (MF), correspondant au milieu biologique ou biochimique à analyser, le biocapteur comprenant :

- un interféromètre à polarisation (I) selon l'une quelconque des revendications 7 ou 8 ou un ellipsomètre selon l'une quelconque des revendications 9 à 11
- une biopuce amovible (11) supportée par un prisme sur laquelle est déposée une fine couche métallique résonante ou un autre résonateur optique (ME) apte à recevoir la couche microfluidique (MF) à analyser par ledit interféromètre à polarisation ou ledit ellipsomètre, ladite biopuce étant configurée de sorte à intercepter le faisceau laser modulé temporellement en phase $(S_{modulé})$ dans lequel :

- l'interaction entre le faisceau laser modulé temporellement en phase $(S_{modulé})$ et l'échantillon consiste en une excitation optique résonante du résonateur (ME) de la biopuce en interaction avec la couche microfluidique (MF), produisant ledit faisceau de sortie $(S_{échantillon})$
- ledit faisceau de sortie $(S_{échantillon})$ caractéristique de l'échantillon (7) est configuré pour être capté par le photo-détecteur d'analyse (8)
- l'unité d'analyse électronique (6b) est configurée pour analyser ledit signal électrique modulé $(I_{échantillon})$ représentatif du faisceau de sortie $(S_{échantillon})$ généré par le photo-détecteur d'analyse (8) afin de déterminer des caractéristiques dudit échantillon (7).

**Patentansprüche**

1. Laservorrichtung (D) für eine Polarisationsinterferometrie, die geeignet ist, einen zeitlich phasenmodulierten Laserstrahl $(S_{moduliert})$ bereitzustellen, und die umfasst:

- eine Longitudinal-Monomode-Laserquelle (1), die mit einem elektrischen Speisestrom gespeist wird und ausgelegt ist, um einen polarisierten Quell-Laserstrahl ($S_{Quell}$) einer Wellenlänge ($\lambda$) bereitzustellen, umfassend zwei von null verschiedene, orthogonale, geradlinige Polarisationskomponenten, die jeweils als transversal elektrisch, TE, und transversal magnetisch, TM, bezeichnet werden,

- ein elektronisches Zeitmodulationsmittel der Laserquelle (2), das ausgelegt ist, um eine zeitliche Modulation der Wellenlänge des Quell-Laserstrahls ($S_{Quell}$) zu steuern

- einen passiven Phasenverzögerer, der zwei Pfade mit unterschiedlichen optischen Längen für die Polarisationskomponenten TE und TM (3) erzeugt, der ausgelegt ist, um den Quell-Laserstrahl ($S_{Quell}$) zu empfangen und aufgrund der Wellenlängenmodulation des Quell-Laserstrahls ($S_{Quell}$) eine zeitlich modulierte Phasenverschiebung zwischen den Komponenten TE und TM einzuführen, um den zeitlich phasenmodulierten Laserstrahl ($S_{moduliert}$) zu liefern, wobei der passive Phasenverzögerer eine Komponente, die Doppelbrechung vorweist, umfasst und ausgelegt ist, um einen gemeinsamen geometrischen Pfad für die Komponenten TE und TM zu schaffen.

2. Laservorrichtung (D) nach Anspruch 1, wobei die Laserquelle (1) ein Halbleiterlaser ist, der durch den elektrischen Speisestrom des Lasers über einen Abstimmbarkeitsbereich von weniger als einem Tausendstel der Wellenlänge wellenlängenmodulierbar ist.

3. Laservorrichtung (D) nach Anspruch 2, wobei die Halbleiterlaserquelle (1) ein Oberflächenemitter VCSEL ist.

4. Laservorrichtung (D) nach Anspruch 3, wobei der Phasenverzögerer (3) einen doppelbrechenden Kristall umfasst, der eine optischen Achse besitzt, die gemäß einer der Polarisationskomponenten TE oder TM des Quell-Laserstrahls ($S_{Quell}$) ausgerichtet ist.

5. Laservorrichtung (D') nach einem der Ansprüche 1 bis 4, ferner umfassend:

- einen Referenzstrahlteiler (4) an einem Ausgang des Phasenverzögerers (3), der zum Aufteilen des Strahls in mindestens zwei Teile ($S_{Referenz}$) und ($S_{moduliert}$) bestimmt ist, wobei der erste Teil ($S_{Referenz}$) ein Referenzabschnitt des zeitlich phasenmodulierten Laserstrahls ($S_{moduliert}$) ist und der Strahlteiler ausgelegt ist, um den Referenzabschnitt in einer anderen Richtung als der des zeitlich phasenmodulierten Laserstrahls ($S_{moduliert}$) zu verbreiten

- einen Referenzphotodetektor (5) umfassend einen Eingang, der ausgelegt ist, um über einen Referenzpolarisator (5') den Referenzabschnitt ($S_{Referenz}$) zu empfangen, und wobei der Referenzphotodetektor (5) ausgelegt ist, um ein erstes interferometrisches Signal in Form eines ersten modulierten elektrischen Signals ($I_{ref}$) zu generieren, das für den Referenzabschnitt ($S_{Referenz}$) repräsentativ ist

- eine elektronische Referenzanalyseeinheit (6a), die ausgelegt ist, um das elektrische Signal ($I_{ref}$) zu empfangen und zu analysieren, um eine mittlere Phasenverschiebung ($\Delta_{ref}$) zwischen den zwei orthogonalen Komponenten, der transversalen elektrischen TE und der transversalen magnetischen TM, des Referenzabschnitts ($S_{Referenz}$) zu extrahieren, wobei das modulierte elektrische Signal ($I_{ref}$), das für den Referenzabschnitt ($S_{Referenz}$) repräsentativ ist, einen Amplitudenterm ($A_{ref}$), der proportional zu dem Produkt der Amplituden der zwei Komponenten, der transversalen elektrischen TE und der transversalen magnetischen TM, ist, und einen Phasenterm enthält,

wobei die elektronische Referenzanalyseeinheit (6a) ausgelegt ist, um durch Analyse des elektrischen Signals ($I_{ref}$) die mittlere Phasenverschiebung ($\Delta_{ref}$) zwischen den zwei Komponenten, der transversalen elektrischen TE und der transversalen magnetischen TM, des Referenzabschnitts ($S_{Referenz}$) herzuleiten und den Amplitudenterm ($A_{ref}$) zu extrahieren, und

wobei die elektronische Referenzanalyseeinheit (6a) ferner ausgelegt ist, um einen Korrekturkoeffizienten für das Zeitmodulationsmittel der Laserquelle (2) zu liefern, um so die Zeitmodulation der Laserquelle (1) einzustellen und deren mittlere Wellenlänge $\lambda$ durch Stabilisierung der mittleren Phasenverschiebung ($\Delta_{ref}$) zu stabilisieren.

6. Laservorrichtung (D') nach Anspruch 5, wobei die elektronische Referenzanalyseeinheit (6a) mit dem Zeitmodulationsmittel der Laserquelle (2) verbunden ist, so dass sie eine Regelschleife zum Stabilisieren der mittleren Phasenverschiebung ($\Delta_{ref}$) darstellt.

7. Polarisationsinterferometer I, das ausgelegt ist, um Merkmale einer Probe (7) zu messen, umfassend:

- eine Laservorrichtung (D) oder (D') nach einem der Ansprüche 1 bis 6, die geeignet ist, einen zeitlich phasenmodulierten Laserstrahl ($S_{moduliert}$) bereitzustellen;
- eine optomechanische Schnittstelle (70):

    - einen Analysephotodetektor (8) und einen Analysepolarisator (8');
    - eine elektronische Analyseeinheit (6b);

wobei

die optomechanische Schnittstelle (70) ein einfacher Halter für die Probe oder ein optisches Kopplungssystem ist, der/das unterschiedliche Optiken enthalten kann, der/das ausgelegt ist, um den zeitlich phasenmodulierten Laserstrahl ($S_{moduliert}$) zu empfangen und an die Probe (7) zu übertragen, um einen Ausgangsstrahl ($S_{Probe}$) zu generieren,
der Analysephotodetektor (8) einen Eingang umfasst, der ausgelegt ist, um über den Analysepolarisator (8') den Ausgangsstrahl ($S_{Probe}$) zu empfangen, und wobei der Analysephotodetektor (8) ausgelegt ist, um ein zweites interferometrisches Signal in Form eines zweiten modulierten elektrischen Signals ($I_{Probe}$) zu generieren,
die elektronische Analyseeinheit (6b) an den Analysephotodetektor (8) angeschlossen ist und ausgelegt ist, um das modulierte elektrische Signal ($I_{Probe}$) zu empfangen und zu analysieren, um Merkmale der Probe (7) zu bestimmen.

8. Polarisationsinterferometer I nach Anspruch 7, das ausgelegt ist, um optische Merkmale der Probe (7) zu bestimmen, wobei:- die elektronische Analyseeinheit (6b) ausgelegt ist, um durch Analyse des elektrischen Signals ($I_{Probe}$) einen Amplitudenterm ($A_{Probe}$) und einen Mittelphasenterm ($\Delta_{Probe}$) zwischen den zwei Komponenten, der transversalen elektrischen TE und der transversalen magnetischen TM, des Ausgangsstrahls ($S_{Probe}$) zu extrahieren, was die Bestimmung der optischen Merkmale der Probe (7) erlaubt, und,

wenn das Polarisationsinterferometer umfasst:

- einen Referenzstrahlteiler (4) an dem Ausgang des Phasenverzögerers (3), der ausgelegt ist, um den Strahl in mindestens zwei Teile ($S_{Referenz}$) und ($S_{moduliert}$) aufzuteilen, wobei der Teil ($S_{Referenz}$) ein Referenzabschnitt des zeitlich phasenmodulierten Laserstrahls ($S_{moduliert}$) ist und ausgelegt ist, um sich in einer anderen Richtung als der des zeitlich phasenmodulierten Laserstrahls ($S_{moduliert}$) zu verbreiten,
- einen Referenzphotodetektor (5) umfassend einen Eingang, der ausgelegt ist, um über einen Referenzpolarisator (5') den Referenzabschnitt ($S_{Referenz}$) zu empfangen, und wobei der Referenzphotodetektor (5) ausgelegt ist, um ein erstes interferometrisches Signal in Form eines ersten modulierten elektrischen Signals ($I_{ref}$) zu generieren, das für den Referenzabschnitt ($S_{Referenz}$) repräsentativ ist,
- eine elektronische Referenzanalyseeinheit (6a), die ausgelegt ist, um das elektrische Signal ($I_{ref}$) zu empfangen und zu analysieren,

wobei die elektronische Referenzanalyseeinheit (6a) außerdem ausgelegt ist, um eine mittlere Phasenverschiebung ($\Delta_{ref}$) zwischen den zwei Komponenten, der transversalen elektrischen TE und der transversalen magnetischen TM, des Referenzabschnitts ($S_{Referenz}$) zu extrahieren, um bis auf eine additive Konstante ein Inkrement der optischen Phasenverschiebung ($\Delta$), durch die Probe induziert, nach der Formel $\Delta = \Delta_{Probe} - \Delta_{ref}$ zu berechnen.

9. Ellipsometer, das ausgelegt ist, um in Reflexion betrieben zu werden, und ausgelegt ist, um einen ellipsometrischen Parameter ($\Delta_{Ellipsometrie}$) einer Probe (7) zu bestimmen, umfassend ein Polarisationsinterferometer I nach Anspruch 8 und wobei:

die optomechanische Schnittstelle (70) des Polarisationsinterferometers (I) fähig ist, die Probe (7) zu empfangen, und
wenn die Laservorrichtung eine Laservorrichtung D' ist, umfassend:

- einen Referenzstrahlteiler (4) an dem Ausgang des Phasenverzögerers (3), der ausgelegt ist, um den Strahl in mindestens zwei Teile ($S_{Referenz}$) und ($S_{moduliert}$) aufzuteilen, wobei der Teil ($S_{Referenz}$) ein Referenzabschnitt des zeitlich phasenmodulierten Laserstrahls ($S_{moduliert}$) ist und ausgelegt ist, um sich in einer anderen Richtung als der des zeitlich phasenmodulierten Laserstrahls ($S_{moduliert}$) zu verbreiten,
- einen Referenzphotodetektor (5) umfassend einen Eingang, der ausgelegt ist, um über einen Referenzpolarisator (5') den Referenzabschnitt ($S_{Referenz}$) zu empfangen, und wobei der Referenzphotodetektor (5) ausgelegt ist, um ein erstes interferometrisches Signal in Form eines ersten modulierten elektrischen Signals ($I_{ref}$) zu generieren, das für den Referenzabschnitt ($S_{Referenz}$) repräsentativ ist,
- eine elektronische Referenzanalyseeinheit (6a), die ausgelegt ist, um das elektrische Signal ($I_{ref}$) zu empfangen und zu analysieren, dann

die elektronische Referenzanalyseeinheit (6a) ausgelegt ist, durch Analyse des elektrischen Signals ($I_{ref}$) eine mittlere Phasenverschiebung ($\Delta_{ref}$) zwischen den zwei Komponenten, der transversalen elektrischen TE und der transversalen magnetischen TM, des Referenzabschnitts ($S_{Referenz}$) zu extrahieren, um den ellipsometrischen Parameter ($\Delta_{Ellipsometrie}$) durch die Formel ($\Delta_{Ellipsometrie}$) = ($\Delta_{Probe}$) - ($\Delta_{ref}$) bis auf eine additive Konstante zu erhalten.

10. Ellipsometer nach Anspruch 9, das ausgelegt ist, um einen ellipsometrischen Parameter ($\tan_\Psi$) einer Probe (7) zu bestimmen, und das einen zusätzlichen ersten Detektionsweg umfasst, wobei der zusätzliche erste Detektionsweg umfasst:

- eine erste polarisationsselektive Strahlteilervorrichtung (9a), die ausgelegt ist, um einen Abschnitt des Ausgangsstrahls ($S_{Probe}$) zu entnehmen und eine der zwei Komponenten, der transversalen elektrischen TE und der transversalen magnetischen TM, des Ausgangsstrahls ($S_{Probe}$) in Form eines Strahls ($S_{\tan\Psi}$) auszuwählen, der polarisierter Abschnitt genannt wird
- einen Photodetektor für komplette Ellipsometrie (10), der ausgelegt ist, um den polarisierten Abschnitt ($S_{\tan\Psi}$) zu empfangen und ein elektrisches Signal ($I_{\tan\Psi}$) zu generieren, das für die Lichtintensität des polarisierten Abschnitts kennzeichnend ist, wobei der erste zusätzliche Detektionsweg ausgelegt ist, um den ellipsometrischen Parameter ($\tan_\Psi$) der Probe mit Hilfe der elektrischen Signale ($I_{Probe}$) und ($I_{\tan\Psi}$) von dem analysierenden Photodetektor (8) beziehungsweise dem Photodetektor für komplette Ellipsometrie (10) zu bestimmen.

11. Ellipsometer nach Anspruch 9, das ausgelegt ist, um einen ellipsometrischen Parameter ($\tan_\Psi$) einer Probe (7) zu bestimmen, und das ferner einen zusätzlichen zweiten Detektionsweg umfasst, wobei der zusätzliche zweite Detektionsweg umfasst:

- eine zweite polarisationsselektive Strahlteilervorrichtung (9a), die ausgelegt ist, um einen Abschnitt des Ausgangsstrahls ($S_{Probe}$) zu entnehmen und die zwei Komponenten, die transversale elektrische TE und die transversale magnetische TM, des Ausgangsstrahls ($S_{Probe}$) in Form zweier Strahlen ($S_{\tan\Psi\_TE}$) und ($S_{\tan\Psi\_TM}$) auszuwählen, die jeweils polarisierter Abschnitt TE und polarisierter Abschnitt TM genannt werden
- zwei Photodetektoren (101) und (102), die Photodetektor TE und Photodetektor TM genannt werden, die ausgelegt sind, um den polarisierten Abschnitt TE ($S_{\tan\Psi\_TE}$) beziehungsweise den polarisierten Abschnitt TM ($S_{\tan\Psi\_TM}$) zu empfangen und jeweils ein elektrisches Signal ($I_{\tan\Psi\_TE}$), das für die Lichtintensität des polarisierten Abschnitts TE ($S_{\tan\Psi\_TE}$) kennzeichnend ist, und ein elektrisches Signal ($I_{\tan\Psi\_TM}$), das für die Lichtintensität des polarisierten Abschnitts TM ($S_{\tan\Psi\_TM}$) kennzeichnend ist, zu generieren, wobei der zweite zusätzliche Detektionsweg ausgelegt ist, um den ellipsometrischen Parameter ($\tan_\Psi$) der Probe mit Hilfe der elektrischen Signale ($I_{\tan\Psi\_TE}$) und ($I_{\tan\Psi\_TM}$) von dem Photodetektor TE (101) und dem Photodetektor TM (102) zu bestimmen.

12. Biosensor von einem Typ Oberflächenplasmonenresonanz-Detektionssystem, der ausgelegt ist, um Merkmale einer Probe (7) zu bestimmen, die aus einer mikrofluidischen Schicht (MF) besteht, die dem zu analysierenden biologischen oder biochemischen Medium entspricht, wobei der Biosensor umfasst:

- ein Polarisationsinterferometer (I) nach einem der Ansprüche 7 oder 8 oder ein Ellipsometer nach einem der Ansprüche 9 bis 11
- einen entfernbaren Biochip (11), der von einem Prisma gehalten wird, auf dem eine dünne resonante Metallschicht oder ein anderer optischer Resonator (ME) aufgebracht ist, der fähig ist, die mikrofluidische Schicht (MF) zu empfangen, die von dem Polarisationsinterferometer oder dem Ellipsometer zu analysieren ist, wobei der Biochip ausgelegt ist, um den zeitlich phasenmodulierten Laserstrahl ($S_{moduliert}$) abzufangen, wobei:

- die Wechselwirkung zwischen dem zeitlich phasenmodulierten Laserstrahl ($S_{moduliert}$) und der Probe in einer resonanten optischen Stimulation des Resonators (ME) des Biochips in Wechselwirkung mit der Mikrofluidikschicht (MF) besteht, wobei der Ausgangsstrahl ($S_{Probe}$) erzeugt wird
- der Ausgangsstrahl ($S_{Probe}$), der für die Probe (7) kennzeichnend ist, ausgelegt ist, um von dem Analysephotodetektor (8) aufgenommen zu werden
- die elektronische Analyseeinheit (6b) ausgelegt ist, um das modulierte elektrische Signal ($I_{Probe}$) zu analysieren, das repräsentativ für den Ausgangsstrahl ($S_{Probe}$) ist, der von dem Analysephotodetektor (8) erzeugt wird, um Merkmale der Probe (7) zu bestimmen.

**Claims**

1. A laser device (D) for polarization interferometry adapted to deliver a temporally phase-modulated laser beam ($S_{modulated}$) and comprising:

   - a longitudinal single-mode laser source (1), powered by an electrical power supply current, and configured to deliver a polarized source laser beam ($S_{source}$) of wavelength ($\lambda$), comprising two non-zero orthogonal rectilinear polarization components, respectively called electric transverse, TE, and magnetic transverse, TM,
   - means for electronic temporal modulation of the laser source (2) configured to drive a temporal modulation of the wavelength of the source laser beam ($S_{source}$),
   - a passive phase delay element, producing two paths of different optical lengths for said TE and TM polarization components (3), configured to receive the source laser beam ($S_{source}$) and to introduce, due to the wavelength modulation of the source laser beam ($S_{source}$), a temporally modulated phase shift between said TE and TM components to provide said temporally phase-modulated laser beam ($S_{modulated}$), wherein the passive phase delay element comprises a component having a birefringence and is configured to create a common geometric path for the TE and TM components.

2. The laser device (D) according to claim1 , wherein the laser source (1) is a semiconductor laser which can be wavelength-modulated by the electrical current for powering the laser over a tunability range of less than one thousandth of the wavelength.

3. The laser device (D) according to claim 2, wherein the semiconductor laser type source (1) is a vertical-cavity surface-emitting laser diode VCSEL.

4. The laser device (D) according to claim 3, wherein the phase delay element (3) comprises a birefringent crystal having an optical axis oriented along one of said TE or TM polarization components of the source laser beam ($S_{source}$).

5. The laser device (D') according to one of claims 1 to 4, further comprising:

   - a reference beam splitter (4) at the output of the phase delay element (3) intended to split the beam into at least two portions ($S_{reference}$) and ($S_{modulated}$), the first portion ($S_{reference}$) being a reference portion of the temporally phase-modulated laser beam ($S_{modulated}$), and said beam splitter being configured to propagate the reference portion in a direction different from that of the temporally phase-modulated laser beam ($S_{modulated}$)
   - a reference photo-detector (5) comprising an input intended to receive, via a reference polarizer (5'), said reference portion ($S_{reference}$), and said reference photo-detector (5) being configured to generate a first interferometric signal, in the form of a first modulated electrical signal ($I_{ref}$) representative of said reference portion ($S_{reference}$)
   - a reference electronic analysis unit (6a) configured to receive and analyze said electrical signal ($I_{ref}$) to extract an average phase shift ($\Delta_{ref}$) between the two electric transverse TE and magnetic transverse TM orthogonal components of the reference portion ($S_{reference}$), the modulated electrical signal ($I_{ref}$) representative of said reference portion ($S_{reference}$) including an amplitude term ($A_{ref}$) proportional to the product of the amplitudes of the two electric transverse TE and magnetic transverse TM components and a phase term,
   the reference electronic analysis unit (6a) being configured to, by analysis of said electrical signal ($I_{ref}$), deduce therefrom the average phase shift ($\Delta_{ref}$) between the two electric transverse TE and magnetic transverse TM components of the reference portion ($S_{reference}$), and to extract said amplitude term ($A_{ref}$), and
   the reference electronic analysis unit (6A) being further configured to provide a correction coefficient to the means for temporal modulation of the laser source (2) so as to adjust the temporal modulation of the laser source (1) and to stabilize the average wavelength $\lambda$ thereof by stabilization of the average phase shift ($\Delta_{ref}$).

6. The laser device (D') according to claim 5, wherein said reference electronic analysis unit (6a) is connected to the means for temporal modulation of the laser source (2) so as to constitute a servo-control loop for stabilizing the average phase shift ($\Delta_{ref}$).

**7.** A polarization interferometer I configured to measure characteristics of a sample (7), comprising:

- a laser device (D) or (D') according to any one of claims 1 to 6, adapted to deliver a temporally phase-modulated laser beam ($S_{modulated}$);
- an opto-mechanical interface (70):

  - an analysis photo-detector (8) and an analysis polarizer (8');
  - an electronic analysis unit (6b);

wherein

said opto-mechanical interface (70) being a simple support of the sample or an optical coupling system, which can include different optics, configured to receive and transmit the temporally phase-modulated laser beam ($S_{modulated}$) toward the sample (7) so as to generate an output beam ($S_{sample}$),
the analysis photo-detector (8) comprises an input configured to receive, via the analysis polarizer (8'), said output beam ($S_{sample}$), and said analysis photo-detector (8) being configured to generate a second interferometric signal, in the form of a second modulated electrical signal ($I_{sample}$),
said electronic analysis unit (6b) is connected to the analysis photo-detector (8) and is configured to receive and analyze said modulated electrical signal ($I_{sample}$) to determine characteristics of said sample (7).

**8.** The polarization interferometer I according to claim 7, configured to determine optical characteristics of said sample (7), wherein the electronic analysis unit (6b) is configured to, by analysis of said electrical signal ($I_{sample}$), extract an amplitude term ($A_{sample}$) and an average phase term ($\Delta_{sample}$) between the two electric transverse TE and magnetic transverse TM components of the output beam ($S_{sample}$) allowing determination of the optical characteristics of said sample (7), and

when the polarization interferometer comprises:

- a reference beam splitter (4) at the output of the phase delay element (3) configured to split the beam into at least two portions ($S_{reference}$) and ($S_{modulated}$), said portion ($S_{reference}$) being a reference portion of the temporally phase-modulated laser beam ($S_{modulated}$), and being configured to propagate in a direction different from that of the temporally phase-modulated laser beam ($S_{modulated}$),
- a reference photo-detector (5) comprising an input configured to receive, via a reference polarizer (5'), said reference portion ($S_{reference}$), and said reference photo-detector (5) being configured to generate a first interferometric signal, in the form of a first modulated electrical signal ($I_{ref}$) representative of said reference portion ($S_{reference}$),
- a reference electronic analysis unit (6a) configured to receive and analyze said electrical signal ($I_{ref}$),

said reference electronic analysis unit (6a) is further configured to extract an average phase shift ($\Delta_{ref}$) between the two electric transverse TE and magnetic transverse TM components of the reference portion ($S_{reference}$), so as to calculate, to within an additive constant, an optical phase shift increment ($\Delta$) induced by the sample by the formula $\Delta=\Delta_{sample}- \Delta_{ref}$.

**9.** An ellipsometer configured to operate in reflection, and configured to determine an ellipsometric parameter ($\Delta_{ellipsometry}$) of a sample (7) comprising a polarization interferometer I according to claim 8 and wherein:

the opto-mechanical interface (70) of the polarization interferometer (I) is able to receive the sample (7), and
when the laser device is a laser device D', comprising:

- a reference beam splitter (4) at the output of the phase delay element (3) configured to split the beam into at least two portions ($S_{reference}$) and ($S_{modulated}$), said portion ($S_{reference}$) being a reference portion of the temporally phase-modulated laser beam ($S_{modulated}$), and being configured to propagate in a direction different from that of the temporally phase-modulated laser beam ($S_{modulated}$),
- a reference photo-detector (5) comprising an input configured to receive, via a reference polarizer (5'), said reference portion ($S_{reference}$), and said reference photo-detector (5) being configured to generate a first interferometric signal, in the form of a first modulated electrical signal ($I_{ref}$) representative of said reference portion ($S_{reference}$),

- a reference electronic analysis unit (6a) configured to receive and analyze said electrical signal ($I_{ref}$), then

the reference electronic analysis unit (6a) is configured, by analysis of said electrical signal ($I_{ref}$), to extract an average phase shift ($\Delta_{ref}$) between the two electric transverse TE and magnetic transverse TM components of the reference portion ($S_{reference}$), to obtain the ellipsometric parameter ($\Delta_{ellipsometry}$) by the formula ($\Delta_{ellipsometry}$) = ($\Delta_{sample}$ ▪ ($\Delta_{ref}$) to within an additive constant.

10. The ellipsometer according to claim 9, configured to determine an ellipsometric parameter ($\tan_{\psi}$) of a sample (7) and comprising a first additional detection channel, said first additional detection channel comprising:

- a first polarization-selective beam splitter device (9a), configured to take a portion of the output beam ($S_{sample}$) and select one of the two electric transverse TE and magnetic transverse TM components of the output beam ($S_{sample}$) in the form of a beam ($S_{tan\Psi}$) called polarized portion
- a photo-detector for complete ellipsometry (10) configured to receive said polarized portion ($S_{tan\Psi}$) and to generate an electrical signal ($I_{tan\Psi}$) characteristic of the light intensity of the polarized portion, where said first additional detection channel is configured to determine the ellipsometric parameter ($\tan_{\psi}$) of the sample using the electrical signals ($I_{sample}$) and ($I_{tan\Psi}$) respectively from the analysis photo-detector (8) and the photo-detector for complete ellipsometry (10).

11. The ellipsometer according to claim 9, configured to determine an ellipsometric parameter ($\tan_{\psi}$) of a sample (7) and further comprising a second additional detection channel, said second additional detection channel comprising:

- a second polarization-selective beam splitter device (9b) configured to take a portion of the output beam ($S_{sample}$) and select the two electric transverse TE and magnetic transverse TM components of the output beam ($S_{sample}$) in the form of two beams ($S_{tan\Psi\_TE}$) and ($S_{tan\Psi\_TM}$) called TE polarized portion and TM polarized portion, respectively,
- two photo-detectors (101) and (102) called TE photo-detector and TM photo-detector configured to receive said TE polarized portion ($S_{tan\Psi\_TE}$) and TM polarized portion ($S_{tan\Psi\_TM}$), respectively, and to generate a respective electrical signal ($I_{tan\Psi\_TE}$) characteristic of the light intensity of the TE polarized portion ($S_{tan\Psi\_TE}$) and an electrical signal ($It_{an\Psi\_TM}$) characteristic of the light intensity of the TM polarized portion ($S_{tan\Psi\_TM}$), where the second additional detection channel is configured to determine the ellipsometric parameter ($\tan_{\psi}$) of the sample using the electrical signals ($I_{tan\Psi\_TE}$) and ($I_{tan\Psi\_TM}$) from the TE photo-detector (101) and TM photo-detector (102).

12. A biosensor of the surface plasmon resonance detection system type configured to determine characteristics of a sample (7) consisting of a microfluidic layer (MF), corresponding to the biological or biochemical medium to be analyzed, the biosensor comprising:

- a polarization interferometer (I) according to any one of claims 7 or 8 or an ellipsometer according to any one of claims 9 to 11
- a removable biochip (11), which is supported by a prism, on which is deposited a thin resonant metal layer or another optical resonator (ME) capable of receiving the microfluidic layer (MF) to be analyzed by said polarization interferometer or said ellipsometer, said biochip being configured so as to intercept the temporally phase-modulated laser beam ($S_{modulated}$) wherein:

- the interaction between the temporally phase-modulated laser beam ($S_{modulated}$) and the sample consists of a resonant optical excitation of the resonator (ME) of the biochip in interaction with the microfluidic layer (MF), producing said output beam ($S_{sample}$)
- said output beam ($S_{sample}$) characteristic of the sample (7) is configured to be sensed by the analysis photo-detector (8)
- the electronic analysis unit (6b) is configured to analyze said modulated electrical signal ($I_{sample}$) representative of the output beam ($S_{sample}$) generated by the analysis photo-detector (8) in order to determine characteristics of said sample (7).

Figure 1a

Figure 1b

Figure 2a

Figure 2b

Figure 3a

Figure 3b

Figure 4a

| Echantillon | Verre BK7 : $n_{théorique}$ = 1,5139 |
|---|---|
| Paramètre ellipsométrique mesuré | $\Delta_{mesuré}$ =-180.0° |
| tanψ mesuré | 0,368 |
| Angle d'incidence | 69,92° |
| Indice retrouvé | n=1,514 |

Figure 4b

| Echantillon | Silicium sur isolant (SOI) |
|---|---|
| Epaisseur mesurée avec un ellipsomètre commercial | 120,3 nm |
| Ecart-type sur 5 mesures | 0,13 nm |
| Indice supposé Silicium | n=3.82+0.01i |
| Angle d'incidence | 69,92° |
| Epaisseur retrouvée | 120,4 nm |

Figure 5

Figure 6a

Figure 6b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1893977 B1
- FR 2685962
- WO 2017153378 A
- WO 2009080998 A2
- US 7233396 B2
- US 5305330 A

- US 5374991 A
- US 5485271 A
- US 7339681 B2
- US 8004676 B1
- US 9518869 B2

**Littérature non-brevet citée dans la description**

- **AURÉLIEN BRUYANT et al.** Interferometry Using Generalized Lock-in Amplifier (G-LIA): A versatile approach for Phase-Sensitive Sensing and Imaging. *Optical Interferometry,* 15 Février 2017, 210-211
- Novel interferometric ellipsometer with wavelength swept source. **WATKINS L R.** LASER AND ELECTRO-OPTICS, 2004 (CLEO), CONFERENCE ON SAN FRANCISCO, CA, USA. IEEE, 17 Mai 2004, vol. 1, 1043-1045

- **VAILLANT et al.** An unbalanced interferometer insensitive to wavelength drift. *Sensors and Actuators A: Physical,* 2017, vol. 268, 188-192
- **AL MOHTAR ; ABEER et al.** Generalized lock-in détection for interferometry: application to phase sensitive spectroscopy and near-field nanoscopy. *Optics express,* 2014, vol. 22 (18), 22232-22245
- **VAILLANT et al.** An unbalanced interferometer insensitive to wavelength drift. *Sensors and Actuators A: Physical,* vol. 268, 188-192